# EUROPEAN PATENT APPLICATION

(11) **EP 1 662 614 A1**
(43) Date of publication of application: **31.05.2006**
(21) Application number: 04772307.7
(22) Date of filing: 27.08.2004
(51) Int. Cl.: H01R 11/01

(54) **ANISOTROPIC CONDUCTIVE SHEET PROCESS FOR PRODUCING THE SAME, AND CIRCUIT BOARD INSPECTION APPARATUS**

(30) Priority: 01.09.2003 JP 2003308965
(71) Applicant: JSR Corporation, Tokyo 104-0045 (JP)
(72) Inventor: YAMADA, Daisuke, c/o JSR Microtech Inc., Hidaka-shi, Saitama 350-1236 (JP); KIMURA, Kiyoshi, c/o JSR Microtech Inc., Hidaka-shi, Saitama 350-1236 (JP)
(74) Representative: TBK-Patent
(86) International application number: PCT/JP2004/012351
(87) International publication number: WO 2005/022696

(57) **Abstract**

Disclosed herein are an anisotropically conductive sheet that can retain necessary conductivity over a long period of time upon its repeated use even when its thickness is small, and thus permits achieving high resolving power and long service life, a production process thereof, and an inspection apparatus for circuit boards equipped with this anisotropically conductive sheet.

The anisotropically conductive sheet of the invention comprises a base material composed of an insulating elastic polymeric substance and a great number of conductive particles exhibiting magnetism, which are contained in the base material in a state oriented in a thickness-wise direction of the sheet to form chains, wherein an insulating reinforcing material formed of mesh is contained in the base material. The production process of the anisotropically conductive sheet of the invention comprises preparing a molding material with conductive particles exhibiting magnetism contained in a polymeric substance-forming material, which will become an elastic polymeric substance by being cured, forming a molding material layer containing a reinforcing material formed of mesh in a state immersed in the molding material, and subjecting the molding material layer to a curing treatment while applying or after an application of a magnetic field to the molding material layer in a thickness-wise direction thereof.

## Description

### TECHNICAL FIELD

The present invention relates to an anisotropically conductive sheet preferably used as a connector in electrical connection between circuit devices, for example, electronic parts, or in an inspection apparatus for circuit boards such as printed circuit boards, a production process thereof, and an inspection apparatus for circuit boards, which is equipped with this anisotropically conductive sheet.

### BACKGROUND ART

An anisotropically conductive sheet is a sheet exhibiting conductivity only in its thickness-wise direction or having pressure-sensitive conductive conductor parts exhibiting conductivity only in its thickness-wise direction when it is pressurized in the thickness-wise direction. Since the anisotropically conductive sheet has such features that compact electrical connection can be achieved without using any means such as soldering or mechanical fitting, and that soft connection is feasible with mechanical shock or strain absorbed therein, it is widely used as a connector for achieving electrical connection between a circuit device, for example, a printed circuit board, and a leadless chip carrier, liquid crystal panel or the like in fields of, for example, electronic computers, electronic digital clocks, electronic cameras and computer key boards.

On the other hand, in electrical inspection of circuit boards such as printed circuit boards, in order to achieve electrical connection between electrodes to be inspected formed on one surface of a circuit board, which is an object of inspection, and inspection electrodes formed on a front surface of a circuit board for inspection, it is conducted to cause an anisotropically conductive sheet to intervene between a region of electrodes to be inspected of the circuit board and a region of inspection electrodes of the circuit board for inspection.

As such anisotropically conductive sheets, those of various structures have heretofore been known. For example, Patent Art. 1 or the like discloses an anisotropically conductive sheet (hereinafter referred to as "dispersion type anisotropically conductive sheet") obtained by uniformly dispersing metal particles in an elastomer, and Patent Art. 2 or the like discloses an anisotropically conductive sheet (hereinafter referred to as "uneven distribution type anisotropically conductive sheet") obtained by unevenly distributing particles of a conductive magnetic substance in an elastomer to form a great number of conductive path-forming parts extending in a thickness-wise direction thereof and an insulating part mutually insulating them. Further, Patent Art. 3 or the like discloses an uneven distribution type anisotropically conductive sheet with a difference in level defined between the surface of each conductive path-forming part and an insulating part.

These anisotropically conductive sheets are obtained by charging a molding material with conductive particles exhibiting magnetism contained in a polymeric substance-forming material, which will become an elastic polymeric substance by being cured, into a mold, thereby forming a molding material layer having a necessary thickness, applying a magnetic field to the molding material layer in a thickness-wise direction thereof and subjecting the molding material layer to a curing treatment. In such an anisotropically conductive sheet, the conductive particles are contained in a base material composed of the elastic polymeric substance in a state oriented so as to align in the thickness-wise direction, and a conductive path is formed by a chain of a great number of the conductive particles.

Among such anisotropically conductive sheets, the dispersion type anisotropically conductive sheet has the advantage of the following points compared with the uneven distribution type anisotropically conductive sheet.
(1) The uneven distribution type anisotropically conductive sheet needs to be produced by using a special and expensive mold, whereas the dispersion type anisotropically conductive sheet can be produced at low cost without using such a mold.
(2) The uneven distribution type anisotropically conductive sheet needs to form conductive path-forming parts in accordance with a pattern corresponding to a pattern of, for example, electrodes to be inspected and is individually produced according to a circuit board that is an object of inspection, whereas the dispersion type anisotropically conductive sheet can be used irrespective of the pattern of electrodes to be inspected and thus has general-purpose property.
(3) Since the uneven distribution type anisotropically conductive sheet exhibits conductivity in its conductive path-forming parts in the thickness-wise direction thereof and does not exhibit conductivity in its insulating part, positioning of the conductive path-forming parts to electrodes to be inspected is required when the uneven distribution type anisotropically conductive sheet is used, whereas the dispersion type anisotropically conductive sheet exhibits conductivity over the whole surface thereof in the thickness-wise direction thereof, and so positioning of the conductive path-forming parts to the electrodes to be inspected is unnecessary, and an electrically connecting operation becomes easy.

On the other hand, in the uneven distribution type anisotropically conductive sheet, the insulating part mutually insulating adjoining conductive path-forming parts is formed between the adjoining conductive path-forming parts, so that the uneven distribution type anisotropically conductive sheet has the advantage of having performance that electrical connection to respective electrodes to be inspected can be achieved with high reliability in a state that necessary insulating property has been retained between adjoining electrodes to be inspected even about a circuit board, in which the electrodes to be inspected are arranged at a small pitch, i.e., high resolving power compared with the dispersion type anisotropically conductive sheet.

In the dispersion type anisotropically conductive sheet on the other hand, it is necessary to make its thickness small for improving its resolving power.

However, the anisotropically conductive sheet having a small thickness tends to cause permanent deformation by contact under pressure and deformation by abrasion when it is used repeatedly. As a result, its conductivity is deteriorated prematurely, so that such an anisotropically conductive sheet is difficult to have long service life. Accordingly, the use of such an anisotropically conductive sheet in inspection of a great number of circuit boards involves a problem that inspection efficiency is lowered, and increase in inspection cost is incurred because the frequency of exchanging the anisotropically conductive sheet into new one becomes high.
Patent Art. 1: Japanese Patent Application Laid-Open No. 93393/1976;
Patent Art. 2: Japanese Patent Application Laid-Open No. 147772/1978;
Patent Art. 3: Japanese Patent Application Laid-Open No. 250906/1986.

### DISCLOSURE OF THE INVENTION

The present invention has been made on the basis of the foregoing circumstances and has as its first object the provision of an anisotropically conductive sheet that can retain necessary conductivity over a long period of time upon its repeated use even when its thickness is small, and thus permits achieving high resolving power and long service life.

A second object of the present invention is to provide a process capable of producing an anisotropically conductive sheet that can retain necessary conductivity over a long period of time upon its repeated use even when its thickness is small, and thus permits achieving high resolving power and long service life.

A third object of the present invention is to provide an inspection apparatus for circuit board, which is equipped with such an anisotropically conductive connector as described above.

The anisotropically conductive sheet according to the present invention is an anisotropically conductive sheet comprising a base material composed of an insulating elastic polymeric substance and a great number of conductive particles exhibiting magnetism, which are contained in the base material in a state oriented in a thickness-wise direction of the sheet to form chains, wherein
an insulating reinforcing material formed of mesh is contained in the base material.

In the anisotropically conductive sheet according to the present invention, the mesh making up the reinforcing material may preferably be formed by organic fiber.

The chains by the conductive particles may preferably be formed in a state dispersed in a plane direction of the sheet.

The anisotropically conductive sheet may preferably have a thickness of 20 to 500 µm.

A ratio of the thickness of the reinforcing material to the thickness of the anisotropically conductive sheet may preferably be 0.1 to 1.

An average opening diameter of the mesh making up the reinforcing material may preferably be 10 to 800 µm.

A ratio r/R of a number average particle diameter r of the conductive particles to the average opening diameter R of the mesh may preferably be 0.01 to 0.9.

The process according to the present invention for producing an anisotropically conductive sheet comprises the steps of:
preparing a flowable molding material comprising a polymeric substance-forming material, which will become an elastic polymeric substance by being cured, and conductive particles exhibiting magnetism contained in the polymeric substance-forming material,
forming a molding material layer containing a reinforcing material formed of mesh in a state immersed in the molding material, and
subjecting the molding material layer to a curing treatment while applying or after an application of a magnetic field to the molding material layer in a thickness-wise direction thereof.

The inspection apparatus for circuit boards according to the present invention comprises the anisotropically conductive sheet described above.

According to the anisotropically conductive sheet of the present invention, the insulating reinforcing material formed of the mesh is contained, so that permanent deformation by contact under pressure or deformation by abrasion can be inhibited even when its thickness is small. Therefore, necessary conductivity can be retained over a long period of time even when the anisotropically conductive sheet is used repeatedly, so that long service life can be achieved. In addition, since the thickness can be made small, the anisotropically conductive sheet can be provided as that having high resolving power.

According to the process of the present invention for producing the anisotropically conductive sheet, there can be provided an anisotropically conductive sheet that can retain necessary conductivity over a long period of time upon its repeated use even when its thickness is small, and thus permits achieving high resolving power and long service life.

According to the inspection apparatus for circuit boards of the present invention, the above-described anisotropically conductive sheet is installed therein, so that inspection can be conducted with high reliability over a long period of time, and moreover necessary electrical connection can be surely achieved even to a circuit board to be inspected, in which minute electrodes to be inspected are arranged at a small pitch. In addition, the frequency of exchanging the anisotropically conductive sheet into new one is reduced when a great number of circuit boards are inspected. As a result, inspection efficiency can be improved, and inspection cost can be reduced.

### BRIEF DESCRIPTION OF THE DRAWINGS

Fig. 1 is a cross-sectional view illustrating the construction of an exemplary anisotropically conductive sheet according to the present invention.
Fig. 2 is a cross-sectional view illustrating, on an enlarged scale, a part of the anisotropically conductive sheet shown in Fig. 1.
Fig. 3 is a cross-sectional view illustrating a one surface-side molding member, an other surface-side molding member and a spacer for producing the anisotropically conductive sheet according to the present invention.
Fig. 4 is a cross-sectional view illustrating a state that the one surface-side molding member has been superimposed on a molding material applied on to a molding surface of the other surface-side molding member.
Fig. 5 is a cross-sectional view illustrating a state that a molding material layer having a required thickness has been formed between the one surface-side molding member and the other surface-side molding member.
Fig. 6 is a cross-sectional view illustrating a distributed state of conductive particles in the molding material layer.
Fig. 7 is a cross-sectional view illustrating an apparatus for producing the anisotropically conductive sheet shown in Fig. 1.
Fig. 8 is a cross-sectional view illustrating a state that a magnetic field has bee applied to the molding material layer in a thickness-wise direction thereof to form chains.
Fig. 9 illustrates the construction of an exemplary inspection apparatus for circuit boards according to the present invention.
Fig. 10 is a cross-sectional view illustrating, on an enlarged scale, a principal part of the inspection apparatus for circuit boards shown in Fig. 9.
Fig. 11 is a cross-sectional view illustrating, on an enlarged scale, a principal part of an upper-side electrode plate device in the inspection apparatus for circuit boards shown in Fig. 9.
Fig. 12 is a cross-sectional view illustrating, on an enlarged scale, a principal part of a lower-side electrode plate device in the inspection apparatus for circuit boards shown in Fig. 9.
Fig. 13 illustrates a positional relation between a proximal end-side supporting plate in the lower side electrode plate device and an alignment movable plate in a circuit board-holding mechanism, in which (a) is a plan view, and (b) is a side-sectional view.
Fig. 14 illustrates a positional relation between an upper-side supporting point and a lower-side supporting point on a plane of projection when an upper-side jig for inspection and a lower-side jig for inspection are seen through in a thickness-wise direction in the inspection apparatus for circuit boards shown in Fig. 9.
Fig. 15 typically illustrates a measured state in the inspection apparatus for circuit boards shown in Fig. 9.
Fig. 16 illustrates the construction of another exemplary inspection apparatus for circuit boards according to the present invention.
Fig. 17 illustrates, on an enlarged scale, a principal part of the inspection apparatus for circuit boards shown in Fig. 16.
Fig. 18 illustrates, on an enlarged scale, an upper-side adaptor in the inspection apparatus for circuit boards shown in Fig. 16

### [Description of Characters]

- 1: ircuit board to be inspected,
- 2: pper-side electrodes to be inspected,
- 3: Lower-side electrodes to be inspected,
- 10: Anisotropically conductive sheet,
- 10A: Molding material layer,
- 10B: Molding material,
- 11: Base material,
- 12: Reinforcing material,
- 14: One surface-side molding member,
- 15: Other surface-side molding member,
- 16: Spacer
- 16K: Opening,
- 17: Pressure roll,
- 18: Supporting roll,
- 19: Pressure roll device,
- 20: Upper-side jig for inspection,
- 21: Anisotropically conductive sheet,
- 25: Upper-side electrode plate device,
- 26: Inspection electrode pins,
- 26A: Body parts,
- 26B: Electrode parts,
- 26C: Flange parts,
- 27: Electrode pin-supporting member,
- 28: Proximal-side supporting plate,
- 28H: Through-holes,
- 29: Tip-side supporting plate,
- 29H: Through-holes,
- 30: Upper-side adaptor,
- 31,: 31A Circuit board for connection,
- 32: Connecting electrodes,
- 32A: Electrodes for current supply,
- 32B: Electrodes for voltage measurement,
- 32C: Pairs of connecting electrodes,
- 33, 33A: Terminal electrodes,
- 34, 34A: Internal wirings,
- 35: Upper-side jig-supporting mechanism,
- 36: Supporting plate for upper-side jig,
- 37: Supports for upper-side jig,
- 37A: Proximal parts,
- 37B: Tip parts,
- 37S: Upper-side supporting points,
- 40: Lower-side jig for inspection,
- 41: Anisotropically conductive sheet,
- 45: Lower-side electrode plate device,
- 46: Inspection electrode pins,
- 46A: Body parts,
- 46B: Electrode parts,
- 46C: Flange parts,
- 47: Electrode pin-supporting member,
- 48: Proximal-side supporting plate,
- 48A: projected part,
- 48H: Through-holes,
- 48K, 49K: Through-hole for positioning pin,
- 49: Tip-side supporting plate,
- 49H: Through-holes,
- 50: Lower-side adaptor,
- 51, 51A: Circuit board for connection,
- 52: Connecting electrodes,
- 52A: Electrodes for current supply,
- 52B: Electrodes for voltage measurement,
- 52C: Pairs of connecting electrodes,
- 53, 53A: Terminal electrodes,
- 54, 54A: Internal wirings,
- 55: Lower-side jig-supporting mechanism,
- 56: Supporting plate for lower-side jig,
- 57: Supports for lower-side jig,
- 57A: Proximal parts,
- 57B: Tip parts,
- 57S: Lower-side supporting points,
- 60: Circuit board-holding mechanism,
- 61: Positioning pings,
- 62: Alignment movable plate,
- 62H: Hole for movement,
- 63: Supports for movable plate,
- D: Step part,
- G: Great-diameter region,
- M: Electromagnets,
- P: Conductive particles,
- S: Small-diameter region,
- T: Inspection-executing region,
- W: Electric wires.

### BEST MODE FOR CARRYING OUT THE INVENTION

The embodiments of the present invention will hereinafter be described in detail.

### [Anisotropically conductive sheet]

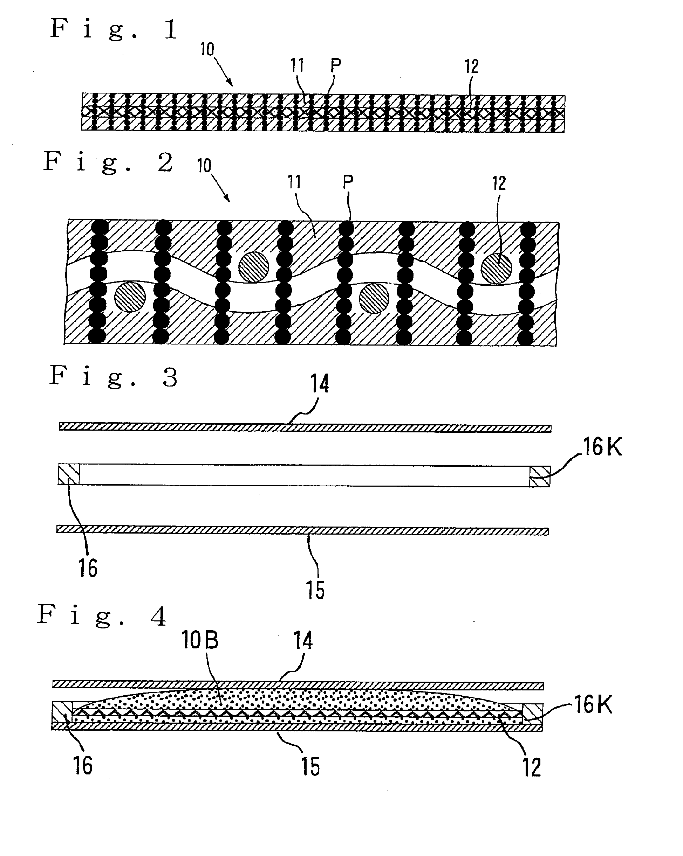

Fig. 1 is a cross-sectional view illustrating the construction of an exemplary anisotropically conductive sheet according to the present invention, and Fig. 2 is a cross-sectional view illustrating, on an enlarged scale, a principal part of the anisotropically conductive sheet shown in Fig. 1. In this anisotropically conductive sheet 10, a great member of conductive particles P exhibiting magnetism are contained in a base material 11 composed of an insulating elastic polymeric substance, and an insulating reinforcing material 12 formed of mesh is also contained therein. The conductive particles P contained in the base material 11 are oriented so as to align in a thickness-wise direction of the anisotropically conductive sheet 10, whereby chains each composed of a plurality of the conductive particles P are formed so as to extend in the thickness-wise direction. The chains by the conductive particles P are formed in a state dispersed in a plane direction of the anisotropically conductive sheet 10.

The thickness of the anisotropically conductive sheet 10 is preferably 20 to 500 µm, more preferably 50 to 200 µm. If this thickness is smaller than 20 µm, the degree of elastic deformation of such an anisotropically conductive sheet 10 in its thickness-wise direction becomes small, and its stress-absorbing ability tends to lower, so that it is liable to damage an objective for connection. If this thickness exceeds 500 µm on the other hand, such an anisotropically conductive sheet tends to have a high electric resistance in the thickness-wise direction. In addition, it may be difficult in some cases to obtain high resolving power.

The elastic polymeric substance forming the base material 11 of the anisotropically conductive sheet 10 is preferably a polymeric substance having a crosslinked structure. As curable polymeric substance-forming materials usable for obtaining a crosslinked polymeric substance, may be used various materials. Specific examples thereof include conjugated diene rubbers such as polybutadiene rubber, natural rubber, polyisoprene rubber, styrene-butadiene copolymer rubber and acrylonitrile-butadiene copolymer rubber, and hydrogenated products thereof; block copolymer rubbers such as styrene-butadiene-diene block terpolymer rubber and styrene-isoprene block copolymers, and hydrogenated products thereof; chloroprene rubber, urethane rubber, polyester rubber, epichlorohydrin rubber, silicone rubber, ethylene-propylene copolymer rubber and ethylene-propylene-diene terpolymer rubber.

When weather resistance is required of the resulting anisotropically conductive sheet 10 in the embodiment described above, any other material than conjugated diene rubbers is preferably used. In particular, silicone rubber is preferably used from the viewpoints of molding or forming and processing ability and electrical properties.

As the silicone rubber, is preferred that obtained by crosslinking or condensing liquid silicone rubber. The liquid silicone rubber preferably has a viscosity not higher than 10⁵ poises as measured at a shear rate of 10⁻¹ sec and may be any of condensation type, addition type and those having a vinyl group or hydroxyl group. As specific examples thereof, may be mentioned dimethyl silicone raw rubber, methylvinyl silicone raw rubber and methylphenylvinyl silicone raw rubber.

Among these, vinyl group-containing liquid silicone rubber (vinyl group-containing dimethyl polysiloxane) is generally obtained by subjecting dimethyldichlorosilane or dimethyldialkoxysilane to hydrolysis and condensation reaction in the presence of dimethylvinylchlorosilane or dimethylvinylalkoxysilane and successively fractionating the reaction product by, for example, repeated dissolution-precipitation.

Liquid silicone rubber having vinyl groups at both terminals thereof is obtained by subjecting a cyclic siloxane such as octamethylcyclotetrasiloxane to anionic polymerization in the presence of a catalyst, using, for example, dimethyldivinylsiloxane as a polymerization terminator and suitably selecting other reaction conditions (for example, amounts of the cyclic siloxane and polymerization terminator). As the catalyst for the anionic polymerization, may be used an alkali such as tetramethylammonium hydroxide or n-butylphosphonium hydroxide or a silanolate solution thereof. The reaction is conducted at a temperature of, for example, 80 to 130°C.

On the other hand, hydroxyl group-containing liquid silicone rubber (hydroxyl group-containing dimethyl polysiloxane) is generally obtained by subjecting dimethyldichlorosilane or dimethyldialkoxysilane to hydrolysis and condensation reaction in the presence of dimethylhydrochlorosilane or dimethylhydroalkoxysilane and successively fractionating the reaction product by, for example, repeated dissolution-precipitation.

The hydroxyl group-containing liquid silicone rubber is also obtained by subjecting a cyclic siloxane to anionic polymerization in the presence of a catalyst, using, for example, dimethylhydrochlorosilane, methyldihydrochlorosilane or dimethylhydroalkoxysilane as a polymerization terminator and suitably selecting other reaction conditions (for example, amounts of the cyclic siloxane and polymerization terminator). As the catalyst for the anionic polymerization, may be used an alkali such as tetramethylammonium hydroxide or n-butylphosphonium hydroxide or a silanolate solution thereof. The reaction is conducted at a temperature of, for example, 80 to 130°C.

As the liquid silicone rubber, is preferably used that having a compression set of at most 35%, more preferably at most 20% as measured in the form of a cured product at 150°C. When this compression set is at most 35%, the resulting anisotropically conductive sheet 10 comes to have good durability when it is compressed repeatedly in its thickness-wise direction. It is hence preferable to use that having such a compression set.

As the liquid silicone rubber, is preferably used that having tear strength of at least 7 kN/m, more preferably at least 10 kN/m as measured in the form of a cured product at 23°C. When this tear strength is at least 7 kN/m, the resulting anisotropically conductive sheet 10 comes to have good durability when it is compressed repeatedly in its thickness-wise direction. It is hence preferable to use that having such tear strength.

In the present invention, the compression set and tear strength of the cured product of the liquid silicone rubber can be measured by methods in accordance with JIS K 6249.

Such an elastic polymeric substance preferably has a molecular weight Mw (weight average molecular weight as determined in terms of standard polystyrene equivalent) of 10,000 to 40,000. It also preferably has a molecular weight distribution index (meaning a value of a ratio Mw/Mn of weight average molecular weight Mw as determined in terms of standard polystyrene equivalent to number average molecular weight Mn as determined in terms of standard polystyrene equivalent) of at most 2 from the viewpoint of heat resistance of the resulting anisotropically conductive sheet 10.

In the above-described anisotropically conductive sheet, a curing catalyst for curing the polymeric substance-forming material may be contained in the polymeric substance-forming material. As such a curing catalyst, may be used an organic peroxide, fatty acid azo compound, hydrosilylated catalyst or the like.

Specific examples of the organic peroxide used as the curing catalyst include benzoyl peroxide, bisdicyclobenzoyl peroxide, dicumyl peroxide and di-tert-butyl peroxide.

Specific examples of the fatty acid azo compound used as the curing catalyst include azobisisobutyronitrile.

Specific examples of that used as the catalyst for hydrosilylation reaction include publicly known catalysts such as platinic chloride and salts thereof, platinum-unsaturated group-containing siloxane complexes, vinylsiloxane-platinum complexes, platinum-1,3-divinyltetramethyldisiloxane complexes, complexes of triorganophosphine or phosphite and platinum, acetyl acetate platinum chelates, and cyclic diene-platinum complexes.

The amount of the curing catalyst used is suitably selected in view of the kind of the polymeric substance-forming material, the kind of the curing catalyst and other curing treatment conditions. However, it is generally 3 to 15 parts by weight per 100 parts by weight of the polymeric substance-forming material.

In the elastic polymeric substance, as needed, may be contained an inorganic filler such as general silica powder, colloidal silica, aerogel silica or alumina. By containing such an inorganic filler, the thixotropic property of the resulting molding material for obtaining the anisotropically conductive sheet 10 is secured, the viscosity thereof becomes high, the dispersion stability of the conductive particles is improved, and moreover the strength of the resulting anisotropically conductive sheet 10 can be made high.

No particular limitation is imposed on the amount of such an inorganic filler used. However, the use in a too great amount is not preferred because the orientation of the conductive particles by a magnetic field cannot be sufficiently achieved.

The viscosity of the sheet-forming material is preferably within a range of 100,000 to 1,000,000 cp at a temperature of 25°C.

As the conductive particles P contained in the base material 11, conductive particles exhibiting magnetism are preferably used from the viewpoint of permitting them to be easily oriented so as to align in a thickness-wise direction of the resulting anisotropically conductive sheet 10 by applying a magnetic field. Specific examples of such conductive particles include particles of metals exhibiting magnetism, such as nickel, iron and cobalt, particles of alloys thereof, particles containing such a metal, particles obtained by using these particles as core particles and plating surfaces of the core particles with a metal having good conductivity, such as gold, silver, palladium or rhodium, particles obtained by using particles of a non-magnetic metal, particles of an inorganic substance, such as glass beads, or particles of a polymer as core particles and plating surfaces of the core particles with a conductive magnetic substance such as nickel or cobalt, and particles obtained by coating the core particles with both conductive magnetic substance and metal having good conductivity.

Among these, particles obtained by using particles composed of a ferromagnetic substance, for example, nickel particles, as core particles and plating their surfaces with a metal having good conductivity, particularly gold are preferably used.

No particular limitation is imposed on a means for coating the surfaces of the core particles with the conductive metal. However, the coating may be conducted by, for example, chemical plating or electroplating.

When those obtained by coating the surfaces of the core particles with the conductive metal are used as the conductive particles P, the coating rate (proportion of an area coated with the conductive metal to the surface area of the core particles) of the conductive metal on the particle surfaces is preferably at least 40%, more preferably at least 45%, particularly preferably 47 to 95% from the viewpoint of achieving good conductivity.

The amount of the conductive metal to coat is preferably 0.5 to 50% by weight, more preferably 1 to 30% by weight, still more preferably 3 to 25% by weight, particularly preferably 4 to 20% by weight based on the core particles. When the conductive metal to coat is gold, the coating amount thereof is preferably 2 to 30% by weight, more preferably 3 to 20% by weight, still more preferably 3.5 to 17% by weight based on the core particles.

The number average particle diameter of the conductive particles P is preferably 1 to 200 µm, more preferably 5 to 50 µm, particularly preferably 8 to 30 µm. If this number average particle diameter is too small, it may be difficult in some cases to obtain an anisotropically conductive sheet having a low electric resistance value. If this number average particle diameter is too great on the other hand, it may be difficult in some cases to obtain an anisotropically conductive sheet having high resolving power.

No particular limitation is also imposed on the form of the conductive particles P. However, they are preferably in the form of a sphere or star, or a mass of secondary particles obtained by aggregating these particles from the viewpoint of permitting them to be easily dispersed in the polymeric substance-forming material.

The content of water in the conductive particles P is preferably at most 5%, more preferably at most 3%, still more preferably at most 2%, particularly preferably at most 1%. The conductive particles P satisfying such conditions are used, thereby preventing or inhibiting occurrence of bubbles when the polymeric substance-forming material is subjected to a curing treatment.

Those obtained by treating surfaces of the conductive particles with a coupling agent such as a silane coupling agent may be suitably used as the conductive particles P. By treating the surfaces of the conductive particles with the coupling agent, the adhesion property of the conductive particles to the elastic polymeric substance is improved. As a result, the resulting anisotropically conductive sheet 10 becomes high in durability upon repeated use.

The amount of the coupling agent used is suitably selected within limits not affecting the conductivity of the conductive particles P. However, it is preferably such an amount that a coating rate (proportion of an area coated with the coupling agent to the surface area of the conductive core particles) of the coupling agent on the surfaces of the conductive particles amounts to at least 5%, more preferably 7 to 100%, still more preferably 10 to 100%, particularly preferably 20 to 100%.

The conductive particles P are preferably contained in the anisotropically conductive sheet 10 in a proportion of 5 to 30%, more preferably 7 to 27%, particularly preferably 10 to 25% in terms of volume fraction. When this proportion is at least 5%, conductive paths sufficiently small in electric resistance value are formed in the thickness-wise direction. When the proportion is at most 30% on the other hand, the resulting anisotropically conductive sheet 10 comes to have necessary elasticity. It is hence preferable to contain the conductive particles P in such a proportion.

In the anisotropically conductive sheet 10, the number of the conductive particles P aligned in the thickness-wise direction (the number of the conductive particles P for forming a conductive path in the thickness-wise direction; hereinafter also referred to as "the number of conductive path-forming particles") is preferably 3 to 20 particles, more preferably 5 to 15 particles. When the number of conductive path-forming particles is 3 particles or more, a scatter of an electric resistance value in such an anisotropically conductive sheet 10 becomes narrow. When the number of conductive path-forming particles is 20 particles or less on the other hand, the deformation of the conductive path by a chain of the conductive particles P does not become great upon compression of such an anisotropically conductive sheet 10, and so increase in resistance value is scarcely incurred. It is hence preferable that the number of the conductive particles be within such a range.

As the insulating mesh making up the reinforcing material 12 contained in the base material 11, may preferably be used that formed by organic fiber.

As examples of such organic fiber, may be mentioned fibers of fluorocarbon resins such as polytetrafluoroethylene, aramide fiber, polyethylene fiber, polyallylate fiber, nylon fiber, and polyester fiber.

In addition, that whose coefficient of linear thermal expansion is equivalent or close to the coefficient of linear thermal expansion of a material forming an objective for connection, for example, a circuit board, specifically, that having a coefficient of linear thermal expansion of 30 x 10⁻⁶ to -5 x 10⁻⁶/K, particularly 10 x 10⁻⁶ to -3 x 10⁻⁶/K is used as the organic fiber, whereby the thermal expansion of the resulting anisotropically conductive sheet 10 is inhibited, so that a good electrically connected state to the circuit board can be stably retained even when the anisotropically conductive sheet 10 is subjected to heat hysteresis by temperature change.

The thickness of the reinforcing material 12 is preferably 10 to 300 µm, more preferably 20 to 100 µm.

If this thickness is too small, it may be difficult in some cases to obtain an anisotropically conductive sheet 10 having high durability. If this thickness is too great on the other hand, the thickness of the resulting anisotropically conductive sheet becomes great as a whole, so that it is difficult to obtain an anisotropically conductive sheet 10 having high resolving power.

The diameter of the organic fiber forming the reinforcing material 12 is preferably 5 to 200 µm, more preferably 10 to 100 µm.

A ratio of the thickness of the reinforcing material 12 to the thickness of the anisotropically conductive sheet 10 is preferably 0.1 to 1, more preferably 0.2 to 0.8. If this ratio is too low, it may be difficult in some cases to obtain an anisotropically conductive sheet 10 having high durability. If this ratio is too high on the other hand, it may be difficult in some cases to obtain an anisotropically conductive sheet 10 having sufficient elasticity.

The average opening diameter of the mesh making up the reinforcing material 12 is preferably 10 to 800 µm, more preferably 20 to 400 µm.

Supposing that the average particle diameter of the conductive particles is r, and the average opening diameter of the mesh is R, a ratio r/R is preferably 0.01 to 0.9, more preferably 0.1 to 0.8.

If the average opening diameter of the mesh is too small, there is a possibility that the orientation of the conductive particles may be inhibited in the production process, which will be described subsequently. If the average opening diameter of the mesh is too great on the other hand, it may be difficult in some cases to obtain an anisotropically conductive sheet 10 having high durability.

In the present invention, an antistatic agent may be contained in the base material 11 forming the anisotropically conductive sheet 10 within limits impairing the insulating property of the elastic polymeric substance.

As such antistatic agents, may be used:
nonionic antistatic agents such as N,N-bis(2-hydroxyethyl)-alkylamines, polyoxyethylene alkylamines, fatty acid esters of polyoxyethylene alkylamines, glycerol fatty acid esters, sorbitan fatty acid esters, polyoxyethylene sorbitan fatty acid esters, polyoxyethylene aliphatic alcohol ethers, polyoxyethylene alkyl phenyl ethers and polyethylene glycol fatty acid esters;
anionic antistatic agents such as alkylsulfonic acid salts, alkylbenzenesulfonic acid salts, alkyl sulfates and alkyl phosphates;
cationic antistatic agents such as tetraalkylammonium salts and trialkylbenzylammonium salts; and
amphoteric antistatic agents such as alkylpetaines and
imidazoline type amphoteric compounds.

Such an antistatic agent is contained in the anisotropically conductive sheet 10, whereby the anisotropically conductive sheet 10 is prevented or inhibited from accumulating electric charge on the surface thereof, so that inconveniences by discharge of electric charge from the anisotropically conductive sheet 10 upon inspection can be prevented, and moreover good conductivity can be achieved with still smaller pressurizing force when the anisotropically conductive sheet is used in electrical inspection of, for example, circuit boards.

In order to surely exhibit such effects as described above, it is preferable to contain the antistatic agent in such a manner that the volume resistivity of the base material composed of the elastic polymeric substance forming the anisotropically conductive sheet 10 is 1 x 10⁹ to 1 x 10¹³ Ω·cm.

The anisotropically conductive sheet 10 according to the present invention can be produced, for example, in the following manner.

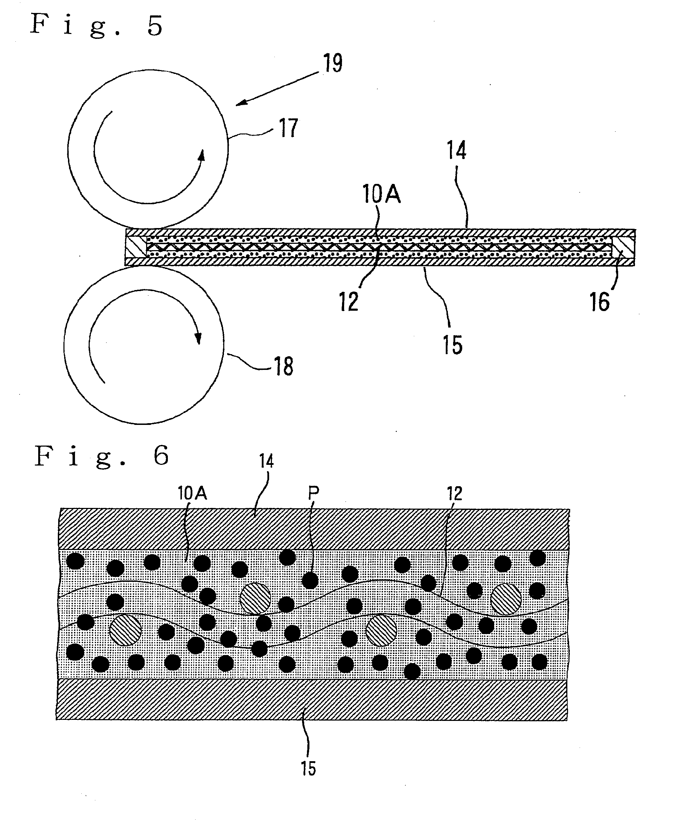

As illustrated in Fig. 3, a one surface-side molding member 14 and an other surface-side molding member 15, which are each in a sheet form, and a frame-like spacer 16 having an opening 16K having a shape fitted to a plane shape of the intended anisotropically conductive sheet 10 and a thickness corresponding to the thickness of the anisotropically conductive sheet 10 are first provided. A flowable molding material with conductive particles exhibiting magnetism dispersed in a liquid polymeric substance-forming material, which will become an elastic polymeric substance by being cured, is then prepared. As illustrated in Fig. 4, the spacer 16 is arranged on a molding surface (upper surface in Fig. 4) of the other surface-side molding member 15, the molding material 10B prepared is applied to within the opening 16K of the spacer 16 on the molding surface of the other surface-side molding member 15, a reinforcing material 12 formed of mesh is immersed in the molding material 10B, and the one surface-side molding member 14 is arranged on this molding material 10B in such a manner that its molding surface (lower surface in Fig. 4) comes into contact with the molding material 10B.

In the above-described process, resin sheets composed of a polyimide resin, polyester resin, acrylic resin or the like may be used as the one surface-side molding member 14 and other surface-side molding member 15. The resin sheets are used as the one surface-side molding member 14 and other surface-side molding member 15 as described above, whereby production cost can be reduced compared with the case where expensive molding members such as molds are used.

The thickness of each of the resin sheets making up the one surface-side molding member 14 and other surface-side molding member 15 is preferably 50 to 500 µm, more preferably 75 to 300 µm. If this thickness is smaller than 50 µm, strength required of the molding member may not be achieved in some cases. If this thickness exceeds 500 µm on the other hand, it may be difficult in some cases to apply a magnetic field of necessary intensity to a molding material layer 10A.

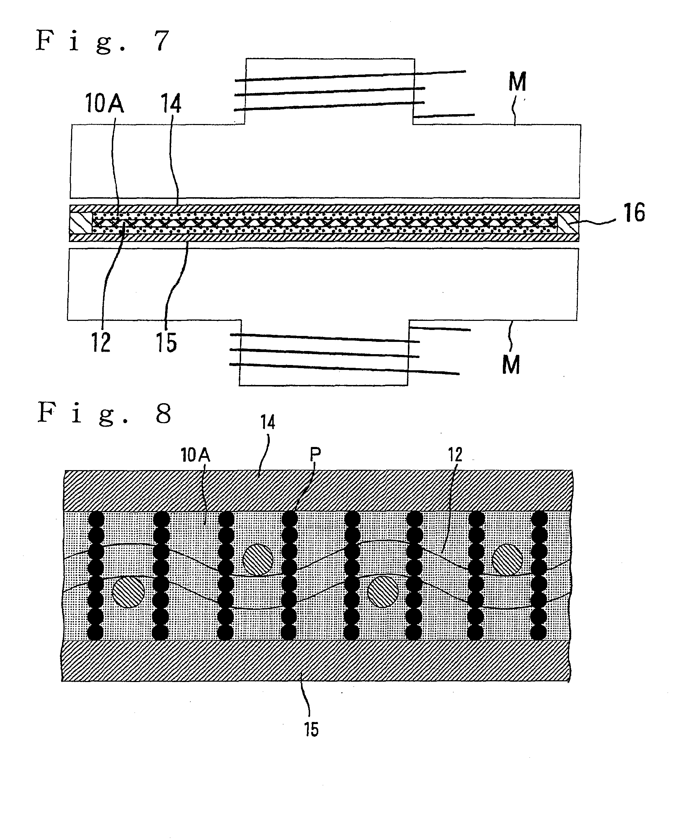

As illustrated in Fig. 5, a pressure roll device 19 composed of a pressure roll 17 and a supporting roll 18 is used to pinch the molding material by the one surface-side molding member 14 and other surface-side molding member 15, thereby forming the molding material layer 10A of a necessary thickness between the one surface-side molding member 14 and the other surface-side molding member 15. In this molding material layer 10A, as illustrated, on an enlarged scale, in Fig. 6, the conductive particles P are contained in a state evenly dispersed and the reinforcing material 12 is contained in a state immersed in the molding material.

As illustrated in Fig. 7, for example, a pair of electromagnets M are then arranged on a back surface (upper surface in the figure) of the one surface-side molding member 14 and a back surface (lower surface in the figure) of the other surface-side molding member 15, and the electromagnets M are operated, thereby applying a parallel magnetic field to the molding material layer 10A in its thickness-wise direction. As a result, in the molding material layer 10A, the conductive particles P dispersed in the molding material layer 10A are oriented so as to align in the thickness-wise direction while retaining the state dispersed in a plane direction as illustrated in Fig. 8, whereby a plurality of chains each composed of the conductive particles P and extending in the thickness-wise direction are formed in the state dispersed in the plane direction.

In this state, the molding material layer 10A is subjected to a curing treatment, thereby producing the anisotropically conductive sheet 10 containing the conductive particles P in a state oriented so as to align in the thickness-wise direction in the base material 11 composed of the elastic polymeric substance and dispersed in the plane direction, and containing the reinforcing material 12.

In the above-described process, the curing treatment of the molding material layer 10A may be conducted in the state that the parallel magnetic field has been applied. However, the treatment may also be conducted after stopping the application of the parallel magnetic field.

The intensity of the parallel magnetic field applied to the molding material layer 10A is preferably an intensity that it amounts to 0.02 to 2.0 T on the average.

As a means for applying the parallel magnetic field to the molding material layer 10A, permanent magnets may also be used in place of the electromagnets. As such permanent magnets, are preferred those composed of alunico (Fe-Al-Ni-Co alloy), ferrite or the like in that the intensity of the parallel magnetic field within the above range is achieved.

The curing treatment of the molding material layer 10A is suitably selected according to the material used. However, the treatment is generally conducted by a heating treatment. Specific heating temperature and heating time are suitably selected in view of the kinds of the polymeric substance-forming material making up the molding material layer 10A, and the like, the time required for movement of the conductive particles P, and the like.

According to the anisotropically conductive sheet 10 described above, the insulating reinforcing material 12 formed of the mesh is contained, so that permanent deformation by contact under pressure or deformation by abrasion can be inhibited even when its thickness is small. Therefore, necessary conductivity can be retained over a long period of time even when the anisotropically conductive sheet 10 is used repeatedly, so that long service life can be achieved. In addition, since the thickness can be made small, the anisotropically conductive sheet can be provided as that having high resolving power.

### <Inspection apparatus for circuit boards>

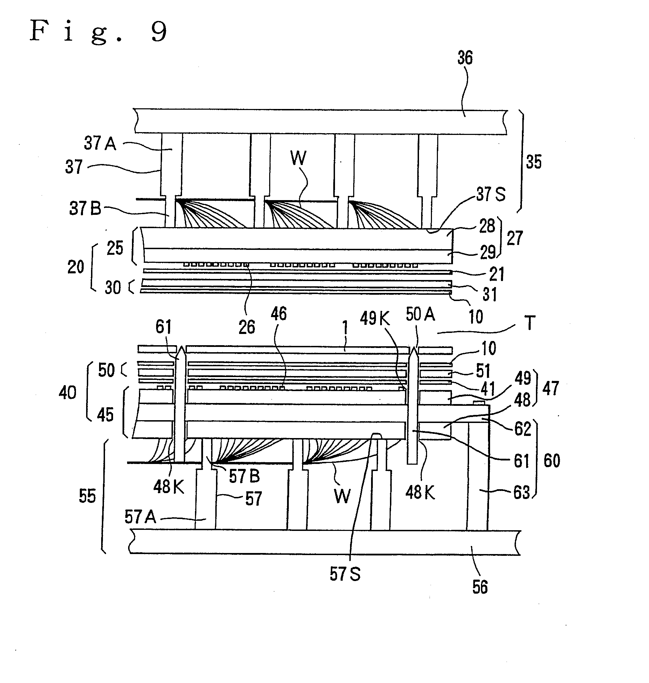

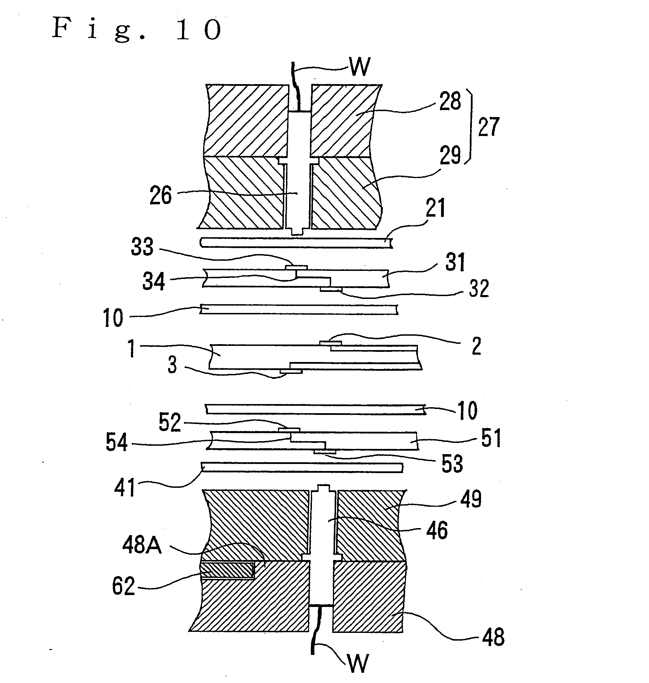

Fig. 9 illustrates the construction of an exemplary inspection apparatus for circuit boards according to the present invention, and Fig. 10 illustrates, on an enlarged scale, a principal part of the inspection apparatus for circuit boards shown in Fig. 9. This inspection apparatus for circuit boards serves to conduct, for example, an open short circuit test on a circuit board on both surfaces of which electrodes to be inspected have been formed.

In this inspection apparatus for circuit boards, an upper-side jig 20 for inspection is provided above an inspection-executing region T in which the circuit board 1 (hereinafter referred to as "circuit board to be inspected") that is an object of inspection is horizontally disposed. On the other hand, a lower-side jig 40 for inspection is provided below the inspection-executing region T. The upper-side jig 20 for inspection and lower-side jig 40 for inspection are supported by an upper-side jig-supporting mechanism 35 and a lower-side jig-supporting mechanism 55, respectively, whereby the upper-side jig 20 for inspection and lower-side jig 40 for inspection are arranged so as to oppose to each other in a vertical direction.

The upper-side jig 20 for inspection is composed of an upper-side electrode plate device 25, an anisotropically conductive sheet 21 arranged on a front surface (lower surface in Figs. 9 and 10) of the upper-side electrode plate device 25 and an upper-side adaptor 30 arranged on a front surface (lower surface in Figs. 9 and 10) of this anisotropically conductive sheet 21.

The upper-side electrode plate device 25 is composed of a great number of inspection electrode pins 26 arranged according to standard lattice-point arrangement and a plate-like electrode pin-supporting member 27 for vertically supporting these inspection electrode pins 26. In the embodiment, an arrangement pitch between the inspection electrode pins 26 is 0.2 mm, 0.3 mm, 0.45 mm, 0.5 mm, 0.75 mm, 0.8 mm, 1.06 mm, 1.27 mm, 1.5 mm, 1.8 mm or 2.54 mm.

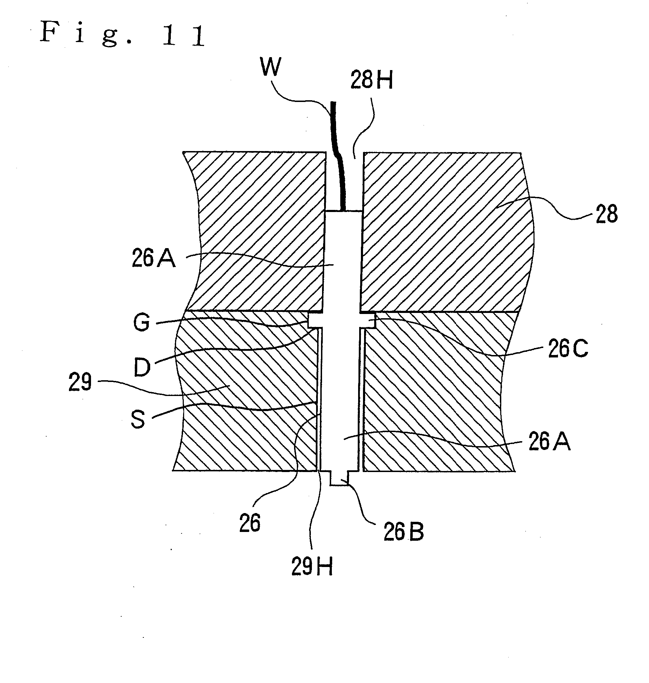

As illustrated, on an enlarged scale, in Fig. 11, each of the inspection electrode pins 26 has a columnar body part 26A, and a columnar electrode part 26B having a diameter smaller than that of the body part 26A is formed integrally with the body part 26A on the tip of the body part 26A. A disk ring-like flange part 26C is formed integrally with the body part 26A at a central position in a longitudinal direction of the body part 26A.

Each of the inspection electrode pins 26 is electrically connected to a connector (not illustrated) provided on the upper-side jig-supporting mechanism 35 through an electric wire W connected to a proximal end of the inspection electrode pin 26, and further electrically connected to an inspection circuit (not illustrated) of a tester through this connector.

The electrode pin-supporting member 27 is constructed by stacking a proximal-side supporting plate 28 for supporting a proximal portion (indicating a portion on the proximal side rather than the flange part 26C) of the body part 26A in each inspection electrode pin 26 and a tip-side supporting plate 29 for supporting a tip portion (indicating a portion on the tip side rather than the flange part 26C) of the body part 26A in each inspection electrode pin 26 on each other.

In the proximal-side supporting plate 28, a great number of through-holes 28H each having an inner diameter fitted to the diameter of the body part 26A in the inspection electrode pin 26 are formed in accordance with a pattern corresponding to an arrangement pattern of the inspection electrode pins 26. The proximal portion in the body part 26A of the inspection electrode pin 26 is inserted into each of these through-holes 28H.

In the tip-side supporting plate 29, a great number of through-holes 29H are formed in accordance with a pattern corresponding to the arrangement pattern of the inspection electrode pins 26. Each of these through-holes 29H is composed of a great-diameter region G formed on the back surface side (upper surface side in Figs. 10 and 11) of the tip-side supporting plate 29 and having an inner diameter fitted to the outer diameter of the flange part 26C of the inspection electrode pin 26 and a small-diameter region S continuously extending from this great-diameter region G to the front surface of the tip-side supporting plate 29 and having an inner diameter fitted to the outer diameter of the body part 26A of the inspection electrode pin 26, and a step D is formed between the small-diameter region S and the great-diameter region G. The tip portion in the body part 26A of the inspection electrode pin 26 is inserted into the small-diameter region S of each of the through-holes 29H, and the flange part 26C of the inspection electrode pin 26 is received in the great-diameter region G to engage with the step D, whereby the inspection electrode pin 26 is fixed in a state that the electrode part 26B of the inspection electrode pin 26 is protruded from the front surface (lower surface in Figs. 10 and 11) of the tip-side supporting plate 29.

In the upper-side electrode plate device 25, as the electrode pin-supporting member 27 is preferably used that having flexibility. Specifically, the electrode pin-supporting member 27 preferably has flexibility to such an extent that it undergoes deflection when it is pressurized by a pressure of 50 kgf in a state arranged at a predetermined position in the inspection apparatus, and it undergoes neither breakage nor permanent set even when it is pressurized by a pressure of 500 kgf.

As a material making up the proximal-side supporting plate 28 and tip-side supporting plate 29 in the electrode pin-supporting member 27, may be used an insulating material having a resistivity of at least 1 x 10¹⁰ Ω·cm, for example, a resin material having high mechanical strength, such as a polyimide resin, polyester resin, polyamide resin, phenol resin, polyacetal resin, poly(butylene terephthalate) resin, poly(ethylene terephthalate) resin, syndiotactic polystyrene resin, poly(phenylene sulfide) resin, poly(ether ethyl ketone) resin, fluorocarbon resin, poly(ether nitrile) resin, poly(ether sulfone) resin, polyallylate resin or polyamideimide resin, a glass fiber composite resin material such as a glass fiber-reinforced epoxy resin, glass fiber-reinforced polyester resin, glass fiber-reinforced polyimide resin, glass fiber-reinforced phenol resin or glass fiber-reinforced fluorocarbon resin, a carbon fiber composite resin material such as a carbon fiber-reinforced epoxy resin, carbon fiber-reinforced polyester resin, carbon fiber-reinforced polyimide resin, carbon fiber-reinforced phenol resin or carbon fiber-reinforced fluorocarbon resin, a composite resin material obtained by filling an inorganic material such as silica, alumina or boron nitride into an epoxy resin, phenol resin or the like, or a composite resin material obtained by containing mesh in an epoxy resin, phenol resin or the like. Among these, a glass fiber-reinforced epoxy resin is preferred. A composite plate material formed by laminating a plurality of plate materials composed of any of these materials may also be used as the proximal-side supporting plate 28 and tip-side supporting plate 29.

The thickness of the proximal-side supporting plate 28 is suitably selected according to the kind of the material making up the proximal-side supporting plate 28. However, it is, for example, 1 to 10 mm.

Specific preferable examples of the proximal-side supporting plate 28 include those composed of a glass fiber-reinforced epoxy resin and having a thickness of 2 to 5 mm.

The overall thickness of the electrode pin-supporting member 27 is, for example, 5 to 15 mm.

The upper-side adaptor 30 is composed of a circuit board 31 for connection and an anisotropically conductive sheet 10 arranged on a front surface (lower surface in Figs. 9 and 10) of the circuit board 31 for connection and having the construction shown in Fig. 1.

On the front surface of the circuit board 31 for connection, a plurality of connecting electrodes 32 are formed in accordance with a pattern corresponding to a pattern of the upper surface-side electrodes 2 to be inspected of the circuit board 1 to be inspected. On the back surface of the circuit board 31 for connection, a plurality of terminal electrodes 33 are formed in accordance with a pattern corresponding to an arrangement pattern of the inspection electrode pins 26 in the upper-side electrode plate device 25. Each of the connecting electrodes 32 is electrically connected to a suitable terminal electrode 33 through an internal wiring 34.

No particular limitation is imposed on the anisotropically conductive sheet 21 so far as a necessary electrically connected state between the inspection electrode pins 26 and the terminal electrodes 33 of the circuit board 31 for connection is achieved, and any of a dispersion type anisotropically conductive sheet and an uneven distribution type anisotropically conductive sheet may be used. As the dispersion type anisotropically conductive sheet, may be used that having the construction shown in Fig. 1.

The lower-side jig 40 for inspection is composed of a lower-side electrode plate device 45, an anisotropically conductive sheet 41 arranged on a front surface (upper surface in Figs. 9 and 10) of the lower-side electrode plate device 45 and a lower-side adaptor 50 arranged on a front surface (upper surface in Figs. 9 and 10) of this anisotropically conductive sheet 41.

The lower-side electrode plate device 45 is composed of a great number of inspection electrode pins 46 arranged according to standard lattice-point arrangement and a plate-like electrode pin-supporting member 47 for vertically supporting these inspection electrode pins 46. In the embodiment, a pitch between the inspection electrode pins 46 is 0.2 mm, 0.3 mm, 0.45 mm, 0.5 mm, 0.75 mm, 0.8 mm, 1.06 mm, 1.27 mm, 1.5 mm, 1.8 mm or 2.54 mm.

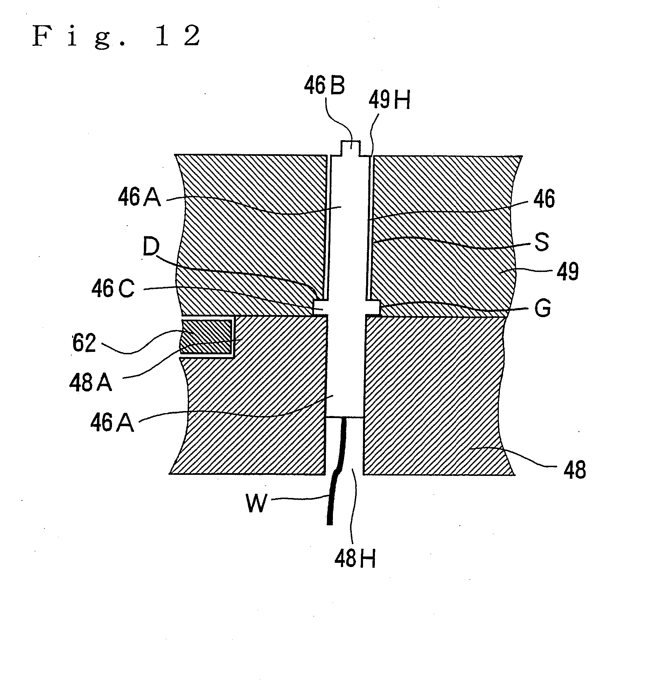

As illustrated, on an enlarged scale, in Fig. 12, each of the inspection electrode pins 46 has a columnar body part 46A, and a columnar electrode part 46B having a diameter smaller than that of the body part 46A is formed integrally with the body part 46A on the tip of the body part 46A. A disk ring-like flange part 46C is formed integrally with the body part 46A at a central position in a longitudinal direction of the body part 46A.

Each of the inspection electrode pins 46 is electrically connected to a connector (not illustrated) provided on the lower-side jig-supporting mechanism 55 through an electric wire W connected to a proximal end of the inspection electrode pin 46, and further electrically connected to an inspection circuit (not illustrated) of a tester through this connector.

The electrode pin-supporting member 47 is constructed by stacking a proximal-side supporting plate 48 for supporting a proximal portion (indicating a portion on the proximal side rather than the flange part 46C) of the body part 46A in each inspection electrode pin 46 and a tip-side supporting plate 49 for supporting a tip portion (indicating a portion on the tip side rather than the flange part 46C) of the body part 46A in each inspection electrode pin 46 on each other.

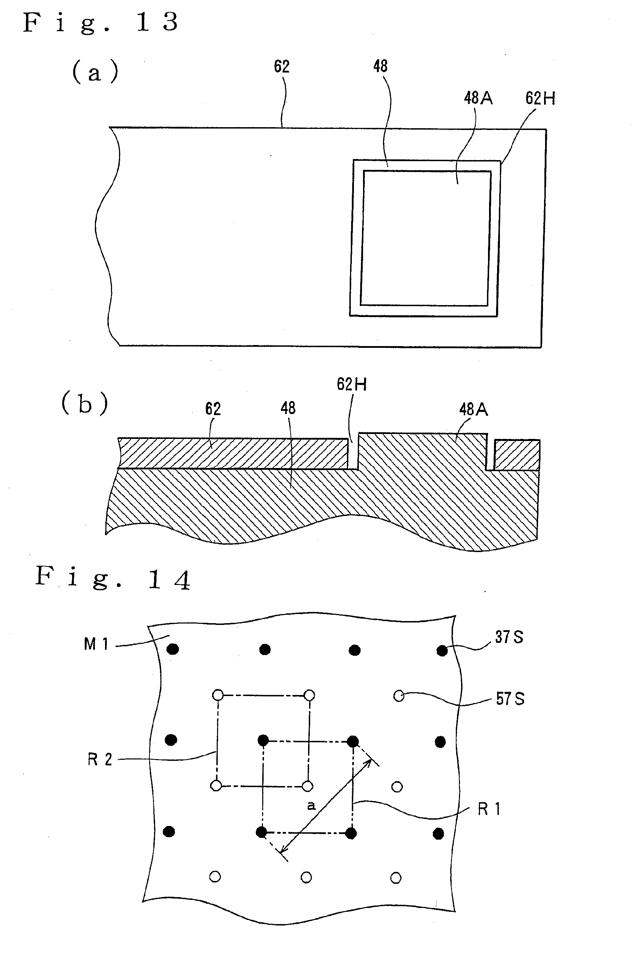

In the proximal-side supporting plate 48, a great number of through-holes 48H each having an inner diameter fitted to the diameter of the body part 46A in the inspection electrode pin 46 are formed in accordance with a pattern corresponding to an arrangement pattern of the inspection electrode pins 46. The proximal portion in the body part 46A of the inspection electrode pin 46 is inserted into each of these through-holes 48H, and the flange part 46C of the inspection electrode pin 46 is engaged with the surface of the proximal-side supporting plate 48. As illustrated in Fig. 13, a substantially rectangular projected part 48A is formed in the whole region, in which the inspection electrode pins 46 are arranged, on the front surface of the proximal-side supporting plate 48.

In the tip-side supporting plate 49, a great number of through-holes 49H are formed in accordance with a pattern corresponding to the arrangement pattern of the inspection electrode pins 46. Each of these through-holes 49H is composed of a great-diameter region G formed on the back surface side (lower surface side in Figs. 10 and 12) of the tip-side supporting plate 49 and having an inner diameter fitted to the outer diameter of the flange part 46C of the inspection electrode pin 46 and a small-diameter region S continuously extending from this great-diameter region G to the front surface of the tip-side supporting plate 49 and having an inner diameter fitted to the outer diameter of the body part 46A of the inspection electrode pin 46, and a step D is formed between the small-diameter region S and the great-diameter region G. The tip portion in the body part 46A of the inspection electrode pin 46 is inserted into the small-diameter region S of each of the through-holes 49H, and the flange part 46C of the inspection electrode pin 46 is received in the great-diameter region G, whereby the inspection electrode pin 46 is fixed in a state that the electrode part 46B of the inspection electrode pin 46 is protruded from the front surface (upper surface in Figs. 10 and 12) of the tip-side supporting plate 49.

In the lower-side electrode plate device 45, as the electrode pin-supporting member 47 is preferably used that having flexibility. Specifically, the electrode pin-supporting member 47 preferably has flexibility to such an extent that it undergoes deflection when it is pressurized by a pressure of 50 kgf in a state arranged at a predetermined position in the inspection apparatus, and it undergoes neither breakage nor permanent set even when it is pressurized by a pressure of 500 kgf.

As a material making up the proximal-side supporting plate 48 and tip-side supporting plate 49 in the electrode pin-supporting member 47, may be used the same material making up the proximal-side supporting plate 28 and tip-side supporting plate 29 in the electrode pin-supporting member 27.

The thickness the proximal-side supporting plate 48 is suitably selected according to the kind of the material making up the proximal-side supporting plate 48. However, it is, for example, 1 to 10 mm. In this embodiment, the thickness of the proximal-side supporting plate 48 in the lower-side electrode plate device 45 indicates a thickness of a portion where the projected part 48A is formed. The projected height of this projected part 48A of the proximal-side supporting plate 48 is preferably 0.5 to 5 mm.

Specific preferable examples of the proximal-side supporting plate 48 include those composed of a glass fiber-reinforced epoxy resin and having a thickness of 2 to 5 mm.

The overall thickness of the electrode pin-supporting member 47 is, for example, 5 to 15 mm.

The lower-side adaptor 50 is composed of a circuit board 51 for connection and an anisotropically conductive sheet 10 arranged on a front surface (upper surface in Figs. 9 and 10) of the circuit board 51 for connection and having the construction shown in Fig. 1.

On the front surface of the circuit board 51 for connection, a plurality of connecting electrodes 52 are formed in accordance with a pattern corresponding to a pattern of the lower surface-side electrodes 3 to be inspected of the circuit board 1 to be inspected. On the back surface of the circuit board 51 for connection, a plurality of terminal electrodes 53 are formed in accordance with a pattern corresponding to an arrangement pattern of the inspection electrode pins 46 in the lower-side electrode plate device 45. Each of the connecting electrodes 52 is electrically connected to a suitable terminal electrode 53 through an internal wiring 54.

No particular limitation is imposed on the anisotropically conductive sheet 41 so far as a necessary electrically connected state between the inspection electrode pins 46 and the terminal electrodes 53 of the circuit board 51 for connection is achieved, and any of a dispersion type anisotropically conductive sheet and an uneven distribution type anisotropically conductive sheet may be used. As the dispersion type anisotropically conductive sheet, may be used that having the construction shown in Fig. 1.

In the embodiment illustrated, a circuit board-holding mechanism 60 for holding the circuit board 1 to be inspected in an inspection-executing region T is provided in the lower-side jig 40 for inspection. This circuit board-holding mechanism 60 has a plurality of positioning pins 61 for arranging the circuit board 1 to be inspected at an expected position in the inspection-executing region T. These positioning pins 61 are provided in such a manner that they are fixed to an alignment movable plate 62 and are each inserted through a through-hole 48K for positioning pin formed in the proximal-side supporting plate 48 in the electrode pin-supporting member 47 and a through-hole 49K for positioning pin formed in the tip-side supporting plate 49.

The alignment movable plate 62 has a thickness fitted to the projected height of the projected part 48A of the proximal-side supporting plate 48 in the electrode pin-supporting member 47 and is supported by supports 63 for movable plate. The supports 63 for movable plate are provided in a supporting plate 56 for lower-side jig in the lower-side jig-supporting mechanism 55, which will be described subsequently, movably in a plane direction of the supporting plate 56. The alignment movable plate 62 has a substantially rectangular hole 62H for movement having a larger size than the plane size of the projected part 48A of the proximal-side supporting plate 48 in the electrode pin-supporting member 47 and is arranged in a such a manner that the projected part 48A of the proximal-side supporting plate 48 is inserted into this hole 62H for movement as illustrated in Fig. 13.

The upper-side jig-supporting mechanism 35 is composed of a flat plate-like supporting plate 36 for upper-side jig, which is horizontally arranged, and a plurality of supports 37 for upper-side jig, which each extend below from a lower surface of this supporting plate 36 for upper-side jig.

In the embodiment illustrated, the supports 37 for upper-side jig is each composed of a columnar proximal end part 37A fixed to the supporting plate 36 for upper-side jig and a columnar tip part 37B formed continuously with this proximal end part 37A and having an outer diameter smaller than the outer diameter of the proximal end part 37A, and upper-side supporting points 37S are formed by the tip surfaces of the supports 37 for upper-side jig.

The upper-side electrode plate device 25 is supported by the respective tip surfaces of the supports 37 for upper-side jig. Specifically, recesses (not illustrated) each having an inner diameter fitted to the outer diameter of the tip part of the support 37 for upper-side jig are formed at respective positions of the upper-side supporting points 37S in a back surface of the upper-side electrode plate device 25, i.e., a back surface of the proximal-side supporting plate 27, and the tip parts of the supports 37 for upper-side jig are inserted into these recesses and fixed, whereby the upper-side electrode plate device 25 is supported.

The lower-side jig-supporting mechanism 55 is composed of a flat plate-like supporting plate 56 for lower-side jig, which is horizontally arranged, and a plurality of supports 57 for lower-side jig, which each extend below from a lower surface of this supporting plate 56 for lower-side jig.

In the embodiment illustrated, the supports 57 for lower-side jig is each composed of a columnar proximal end part 57A fixed to the supporting plate 56 for lower-side jig and a columnar tip part 57B formed continuously with this proximal end part 57A and having an outer diameter smaller than the outer diameter of the proximal end part 57A, and lower-side supporting points 57S are formed by the tip surfaces of the supports 57 for lower-side jig.

The lower-side electrode plate device 45 is supported by the respective tip surfaces of the supports 57 for lower-side jig. Specifically, recesses (not illustrated) each having an inner diameter fitted to the outer diameter of the tip part of the support 57 for lower-side jig are formed at respective positions of the lower-side supporting points 57S in a back surface of the lower-side electrode plate device 45, i.e., a back surface of the proximal-side supporting plate 47, and the tip parts of the supports 57 for lower-side jig are inserted into these recesses and fixed, whereby the lower-side electrode plate device 45 is supported.

In the embodiment described above, as the supporting plate 36 for upper-side jig and supporting plate 56 for lower-side jig, may be used, for example, a laminated plate (trade name: "SUMILITE", product of SUMITOMO BAKELITE Co., Ltd.) of a phenol resin containing a fine thread cloth.

As a material for the supports 37 for upper-side jig and supports 57 for lower-side jig, may be used, for example, brass, aluminum, titanium, stainless steel, copper, iron or an alloy thereof.

The overall length of each of the supports 37 for upper-side jig and supports 57 for lower-side jig is preferably 10 to 100 mm.

The outer diameter of the tip part of each of the supports 37 for upper-side jig and supports 57 for lower-side jig is preferably 1 to 10 mm, and the outer diameter of the tip part of the support 37 for upper-side jig is preferably the same as the outer diameter of the tip part of the support 57 for lower-side jig.

As illustrated in Fig. 14, the supports 37 for upper-side jig and supports 57 for lower-side jig are arranged in such a manner that the upper-side supporting points 37S related to the supports 37 for upper-side jig and the lower-side supporting points 57S related to the supports 57 for lower-side jig do not overlap one another on a plane M1 of projection (hereinafter referred to as "specific plane of projection") when the upper-side jig 20 for inspection and lower-side jig 40 for inspection are seen through in a thickness-wise direction thereof.

In the embodiment illustrated, the supports 37 for upper-side jig and supports 57 for lower-side jig are respectively arranged at positions of lattice points of the same pitch and disposed in such a manner that on the specific plane M1 of projection, one lower-side supporting point 57S is located at a central position of each of rectangular upper-side unit regions R1 (indicating an alternate long and two short dashes line) partitioned by 4 adjoining upper-side supporting points 37S, and one upper-side supporting point 37S is located at a central position of each of rectangular lower-side unit regions R2 (indicating an alternate long and short dash line) partitioned by 4 adjoining lower-side supporting points 57S.

In this embodiment, a center distance between upper-side supporting points 37A adjoining each other and a center distance between lower-side supporting points 57A adjoining each other are each preferably 10 to 100 mm, more preferably 12 to 70 mm, particularly preferably 15 to 50 mm.

In the inspection apparatus of the construction described above, electrical inspection of the circuit board 1 to be inspected is performed in the following manner.

The circuit board 1 to be inspected is first set in the circuit board-holding mechanism 60 to align the circuit board 1 to be inspected by the circuit board-holding mechanism 60. Here, as the circuit board 1 to be inspected, may be any of circuit boards of various constructions. However, in the inspection apparatus of this embodiment, is preferred that having flexibility to such an extent that it undergoes deflection when it is pressurized by a pressure of 50 kgf by the inspection apparatus, and it undergoes neither breakage nor permanent set even when it is pressurized by a pressure of 500 kgf.

Either one or both of the upper-side jig-supporting mechanism 35 and the lower-side jig-supporting mechanism 55 are then moved in direction(s) approaching each other, whereby circuit board 1 to be inspected is held under pressure by the upper-side jig 20 for inspection and the lower-side jig 40 for inspection. As a result, in the upper-side jig 20 for inspection, conductive paths are formed in each of the anisotropically conductive sheet 21 and the anisotropically conductive sheet 10 in the upper-side adaptor 30 in the thickness-wise direction, thereby achieving electrical connection between the inspection electrode pins 26 and the terminal electrodes 33 in the circuit board 31 for connection and electrical connection between the connecting electrodes 32 in the circuit board 31 for connection and the upper-side electrodes 2 to be inspected in the circuit board 1 to be inspected. On the other hand, in the lower-side jig 40 for inspection, conductive paths are formed in each of the anisotropically conductive sheet 41 and the anisotropically conductive sheet 10 in the lower-side adaptor 50 in the thickness-wise direction, thereby achieving electrical connection between the inspection electrode pins 46 and the terminal electrodes 53 in the circuit board 51 for connection and electrical connection between the connecting electrodes 52 in the circuit board 51 for connection and the lower-side electrodes 3 to be inspected in the circuit board 1 to be inspected. This state is a measurable state.

In such a manner, the respective upper-side electrodes 2 to be inspected of the circuit board 1 to be inspected are electrically connected to their corresponding inspection electrode pins 26 through the upper-side adaptor 30 and the anisotropically conductive sheet 21, and the respective lower-side electrodes 3 to be inspected of the circuit board 1 to be inspected are electrically connected to their corresponding inspection electrode pins 46 through the lower-side adaptor 50 and the anisotropically conductive sheet 41, whereby a measurable state that each circuit in the circuit board 1 to be inspected has been electrically connected to an inspection circuit of a tester is achieved. In this state, necessary electrical inspection is carried out.

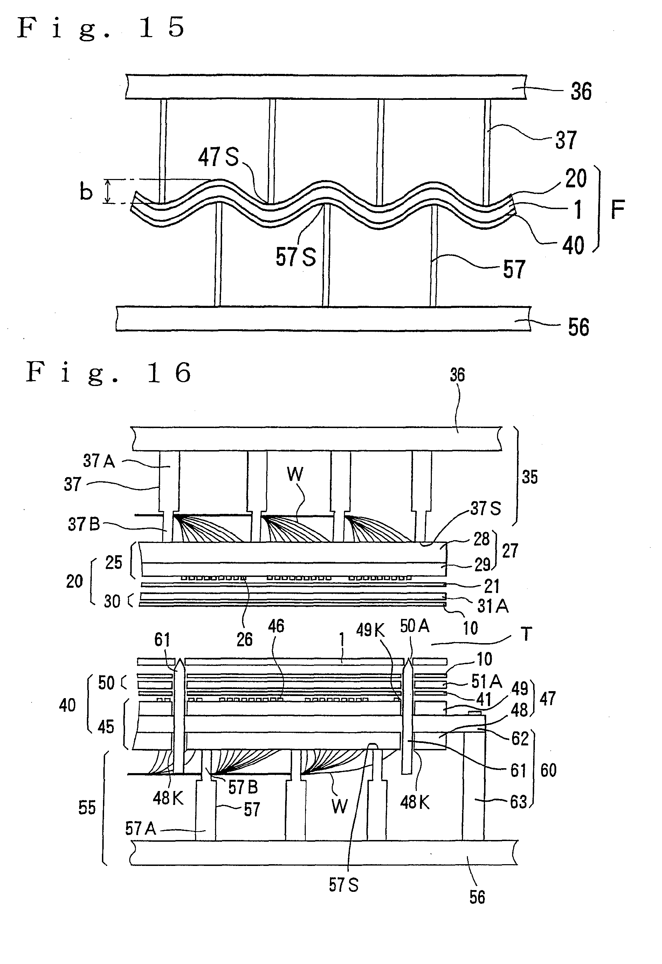

In the above-described measurable state, as typically illustrated in Fig. 15, a gap (hereinafter referred to as "gap between supporting points") between a level (hereinafter referred to as "upper-side supporting point level") at which the tip surface of each of the supports 37 for upper-side jig is located and a level (hereinafter referred to as "lower-side supporting point level") at which the tip surface of each of the supports 57 for lower-side jig is located becomes smaller than the overall thickness of a complex stack F composed of the upper-side jig 20 for inspection, the circuit board 1 to be inspected and the lower-side jig 40 for inspection. Accordingly, the complex stack F is deflected by pressing force at the upper-side supporting points 47S and the lower-side supporting points 57S and thus is in a state deformed in the form of a regular wave.

In such a state, the complex stack F is forcedly deformed in the form of the regular wave, thereby inhibiting the pressing force applied by the supports 37 for upper-side jig and the supports 57 for lower-side jig from concentrating on partial positions in the circuit board 1 to be inspected. As a result, the circuit board 1 to be inspected becomes a state that the whole surface thereof has been held under even pressure.

In the above-described measurable state, the degree b of deflection caused on the complex stack F by the pressure by the supports 37 for upper-side jig and the supports 57 for lower-side jig is preferably 1 down to 0.02%, more preferably 0.5 down to 0.04% of a center distance a (see Fig. 14) between 2 upper-side supporting points 37S located at apex positions diagonal with each other in, for example, the upper-side unit region R1 on the specific plane M1 of projection.

The pressing force against the whole circuit board 1 to be inspected in the measurable state is set to, for example, 110 to 250 kgf.

According to such an inspection apparatus for circuit boards, the anisotropically conductive sheets 10 in the upper-side adaptor 30 and the lower-side adaptor 50 are such that necessary conductivity can be retained even upon repeated use, so that inspection can be conducted with high reliability over a long period of time.

The use of the anisotropically conductive sheets 10 small in thickness permits surely achieving necessary electrical connection even to a circuit board 1 to be inspected, in which minute upper-side electrodes 2 to be inspected and minute lower-side electrodes 3 to be inspected are arranged at a small pitch.

In addition, since the anisotropically conductive sheets 10 have long service life, the frequency of exchanging the anisotropically conductive sheets 10 into new ones is reduced when a great number of circuit boards are inspected. As a result, inspection efficiency can be improved, and inspection cost can be reduced.

Further, the supports 37 for upper-side inspection jig of the upper-side inspection jig-holding mechanism 35 and the supports 57 for lower-side inspection jig of the lower-side inspection jig-holding mechanism 55 are arranged in such a manner that the upper-side supporting points 37S and the lower-side supporting points 57S do not overlap one another on the specific plane M1 of projection, whereby the whole surface of the circuit board 1 to be inspected is held under even pressure, so that stable electrical connection to the circuit board 1 to be inspected can be achieved by relatively small pressurizing force. As a result, the deterioration of the anisotropically conductive sheets 10 by the repeated pressurization can be inhibited. Accordingly, the frequency of exchanging the anisotropically conductive sheets 10 into new ones is more reduced when a great number of circuit boards are inspected.

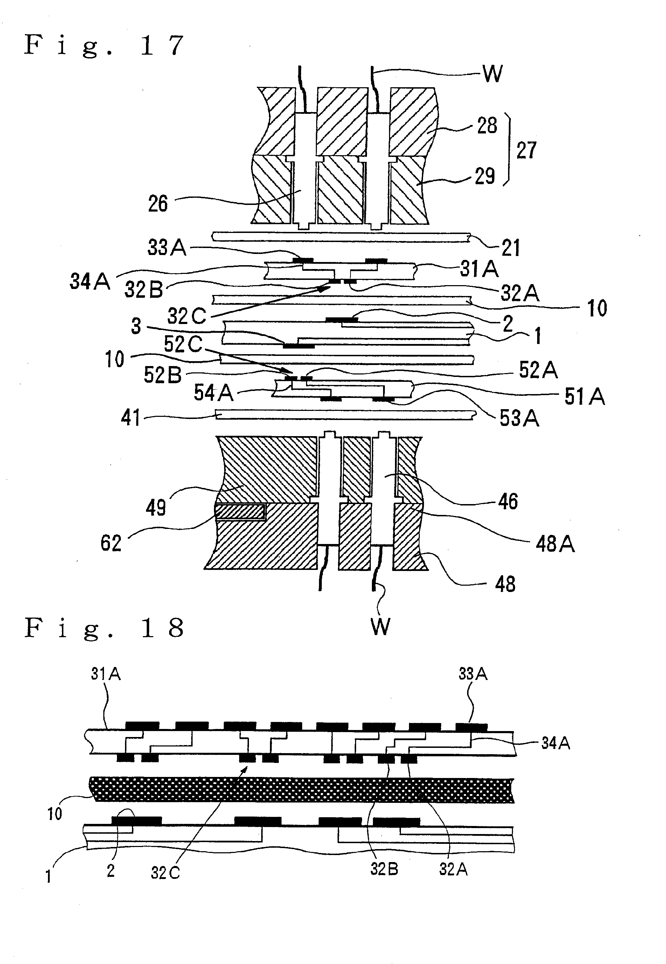

Fig. 16 illustrates the construction of another exemplary inspection apparatus for circuit boards according to the present invention, and Fig. 17 illustrates, on an enlarged scale, a principal part of the inspection apparatus for circuit boards shown in Fig. 16. This inspection apparatus for circuit boards serves to conduct an electric resistance-measuring test of each wiring pattern as to a circuit board, on both surfaces of which electrodes to be inspected have been formed.

In this inspection apparatus for circuit boards, an upper-side jig 20 for inspection is provided above the inspection-executing region T in which a circuit board 1 to be inspected is horizontally disposed, and on the other hand, a lower-side jig 40 for inspection is provided below the inspection-executing region T. The upper-side jig 20 for inspection and lower-side jig 40 for inspection are supported by an upper-side jig-supporting mechanism 35 and a lower-side jig-supporting mechanism 55, respectively, whereby the upper-side jig 20 for inspection and lower-side jig 40 for inspection are arranged so as to oppose to each other in a vertical direction. The upper-side jig-supporting mechanism 35 and lower-side jig-supporting mechanism 55 basically have the same construction as in the upper-side jig-supporting mechanism 35 and lower-side jig-supporting mechanism 55 in the inspection apparatus shown in Fig. 9. The arrangement state of supports 37 for upper-side jig in the upper-side jig-supporting mechanism 35 and supports 57 for lower-side jig in the lower-side jig-supporting mechanism 55 is the same as in the inspection apparatus shown in Fig. 9 (see Fig. 14).

The upper-side jig 20 for inspection is composed of an upper-side electrode plate device 25, an anisotropically conductive sheet 21 arranged on a front surface (lower surface in Figs. 16 and 17) of the upper-side electrode plate device 25 and an upper-side adaptor 30 arranged on a front surface (lower surface in Figs. 16 and 17) of this anisotropically conductive sheet 21. The upper-side electrode plate device 25 and the anisotropically conductive sheet 21 basically have the same construction as in the upper-side electrode plate device 25 and the anisotropically conductive sheet 21 in the inspection apparatus shown in Figs. 9 and 10.

The upper-side adaptor 30 is composed of a circuit board 31A for connection and an anisotropically conductive sheet 10 arranged on a front surface (lower surface in Figs. 16 and 17) of the circuit board 31A for connection and having the construction shown in Fig. 1.

As also illustrated in Fig. 18, on a front surface of the circuit board 31A for connection, plural pairs 32C of connecting electrodes each composed of a connecting electrode (hereinafter also referred to as "electrode for current supply") 32A for current supply and a connecting electrode (hereinafter also referred to as "electrode for voltage measurement") 32B for voltage measurement electrically connected to the same upper-side electrode 2 to be inspected and separately arranged from each other are formed in accordance with a pattern corresponding to a pattern of the upper-side electrodes 2 to be inspected in a circuit board 1 to be inspected. On a back surface of the circuit board 31A for connection, a plurality of terminal electrodes 33A are formed in accordance with a pattern corresponding to an arrangement pattern of inspection electrode pins 26 in the upper-side electrode plate device 25. Each of the electrode 32A for current supply and the electrode 32B for voltage measurement is electrically connected to its corresponding terminal electrode 33A through an internal wiring 34A.

The lower-side jig 40 for inspection is composed of a lower-side electrode plate device 45, an anisotropically conductive sheet 41 arranged on a front surface (upper surface in Figs. 16 and 17) of the lower-side electrode plate device 45, an lower-side adaptor 50 arranged on a front surface (upper surface in Figs. 16 and 17) of this anisotropically conductive sheet 41 and a circuit board-holding mechanism 60. The lower-side electrode plate device 45, the anisotropically conductive sheet 41 and the circuit board-holding mechanism 60 basically have the same construction as in the lower-side electrode plate device 45, the anisotropically conductive sheet 41 and the circuit board-holding mechanism 60 in the inspection apparatus shown in Figs. 9 and 10.

The lower-side adaptor 50 is composed of a circuit board 51A for connection and an anisotropically conductive sheet 10 arranged on a front surface (upper surface in Figs. 16 and 17) of the circuit board 51A for connection and having the construction shown in Fig. 1.

On a front surface of the circuit board 51A for connection, plural pairs 52C of connecting electrodes each composed of an electrode 52A for current supply and an electrode for voltage measurement 52B for voltage measurement electrically connected to the same lower-side electrode 3 to be inspected and separately arranged from each other are formed in accordance with a pattern corresponding to a pattern of the lower-side electrodes 3 to be inspected in the circuit board 1 to be inspected. On a back surface of the circuit board 51A for connection, a plurality of terminal electrodes 53A are formed in accordance with a pattern corresponding to an arrangement pattern of inspection electrode pins 46 in the lower-side electrode plate device 45. Each of the electrode 52A for current supply and the electrode 52B for voltage measurement is electrically connected to its corresponding terminal electrode 53A through an internal wiring 54A.

In the inspection apparatus of the construction described above, electrical inspection of the circuit board 1 to be inspected is performed in the following manner.

The circuit board 1 to be inspected is first set in the circuit board-holding mechanism 60 to align the circuit board 1 to be inspected by the circuit board-holding mechanism 60.

Either one or both of the upper-side jig-supporting mechanism 35 and the lower-side jig-supporting mechanism 55 are then moved in direction(s) approaching each other, whereby circuit board 1 to be inspected is held under pressure by the upper-side jig 20 for inspection and the lower-side jig 40 for inspection. As a result, in the upper-side jig 20 for inspection, conductive paths are formed in each of the anisotropically conductive sheet 21 and the anisotropically conductive sheet 10 in the upper-side adaptor 30 in the thickness-wise direction, thereby achieving electrical connection between the inspection electrode pins 26 and the terminal electrodes 33A in the circuit board 31A for connection and electrical connection between the electrodes 32A for current supply and electrode 32B for voltage measurement in the pairs 32C of connecting electrodes of the circuit board 31A for connection and the upper-side electrodes 2 to be inspected in the circuit board 1 to be inspected. On the other hand, in the lower-side jig 40 for inspection, conductive paths are formed in each of the anisotropically conductive sheet 41 and the anisotropically conductive sheet 10 in the lower-side adaptor 50 in the thickness-wise direction, thereby achieving electrical connection between the inspection electrode pins 46 and the terminal electrodes 53A in the circuit board 51A for connection and electrical connection between the electrodes 52A for current supply and electrode 52B for voltage measurement in the pairs 52C of connecting electrodes of the circuit board 51A for connection and the lower-side electrodes 3 to be inspected in the circuit board 1 to be inspected. This state is a measurable state.

In such a manner, the respective upper-side electrodes 2 to be inspected of the circuit board 1 to be inspected are electrically connected to their corresponding inspection electrode pins 26 through the upper-side adaptor 30 and the anisotropically conductive sheet 21, and the respective lower-side electrodes 3 to be inspected of the circuit board 1 to be inspected are electrically connected to their corresponding inspection electrode pins 46 through the lower-side adaptor 50 and the anisotropically conductive sheet 41, whereby a measurable state that each circuit in the circuit board 1 to be inspected has been electrically connected to an inspection circuit of a tester is achieved. In this state, necessary electrical inspection is carried out. Specifically, a current of a constant value is supplied between the electrode 32A for current supply in the upper-side adaptor 30 and the electrode 52A for current supply in the lower-side adaptor 50, and one electrode is designated among the plurality of the electrodes 32B for voltage measurement in the upper-side adaptor 30, and a voltage between the designated one electrode 32B for voltage measurement and an electrode 52B for voltage measurement in the lower-side adaptor 50, which is electrically connected to a lower-side electrode 3 to be inspected corresponding to an upper-side electrode 2 to be inspected electrically connected to the designated electrode 32B for voltage measurement, is measured, thereby gaining an electric resistance value of a wiring pattern formed between the upper-side electrode 2 to be inspected electrically connected to the designated one electrode 32B for voltage measurement and its corresponding lower-side electrode 52B to be inspected on the basis of the voltage value thus obtained. Measurement of electric resistances on all wiring patterns is conducted by successively changing an electrode 32B for voltage measurement to be designated.

According to such an inspection apparatus for circuit boards, the anisotropically conductive sheets 10 in the upper-side adaptor 30 and the lower-side adaptor 50 are such that necessary conductivity can be retained even upon repeated use, so that inspection can be conducted with high reliability over a long period of time.

The use of the anisotropically conductive sheets 10 small in thickness permits surely achieving necessary electrical connection even to a circuit board 1 to be inspected, in which minute upper-side electrodes 2 to be inspected and minute lower-side electrodes 3 to be inspected are arranged at a small pitch.

In addition, since the anisotropically conductive sheets 10 have long service life, the frequency of exchanging the anisotropically conductive sheets 10 into new ones is reduced when a great number of circuit boards are inspected. As a result, inspection efficiency can be improved, and inspection cost can be reduced.

Further, the supports 37 for upper-side inspection jig of the upper-side inspection jig-holding mechanism 35 and the supports 57 for lower-side inspection jig of the lower-side inspection jig-holding mechanism 55 are arranged in such a manner that the upper-side supporting points 37S and the lower-side supporting points 57S do not overlap one another on the specific plane M1 of projection (see Fig. 14), whereby the whole surface of the circuit board 1 to be inspected is held under even pressure, so that stable electrical connection to the circuit board 1 to be inspected can be achieved by relatively small pressurizing force. As a result, the deterioration of the anisotropically conductive sheets 10 by the repeated pressurization can be inhibited. Accordingly, the frequency of exchanging the anisotropically conductive sheets 10 into new ones is more reduced when a great number of circuit boards are inspected.

The present invention is not limited to the above-described embodiments, and various modifications can be added thereto.

For example, in the anisotropically conductive sheets, an nonwoven fabric can be used as the reinforcing material in place of the mesh. As this nonwoven fabric, is preferred that in which a great number of openings of 10 to 800 µm, particularly 20 to 400 µm are formed. As a means for forming the openings in the nonwoven fabric, may be utilized drilling, punching, laser beam machining or the like.

The inspection apparatus for circuit boards are not limited to those illustrated in Figs. 9 and 16 so far as they have the anisotropically conductive sheet according to the present invention, and various kinds of construction may be adopted.

### EXAMPLES

The present invention will hereinafter be described specifically by the following Examples. However, the present invention is not limited to these Examples.

### <Example 1>

### [Preparation of molding material]

Solution A and Solution B of addition type liquid silicone rubber of a two-pack type were mixed in proportions that their amounts become equal. After 18 parts by weight of conductive particles having an average particle diameter of 15 µm were added to and mixed with 100 parts by weight of this mixture, the resultant mixture was subjected to a defoaming treatment by pressure reduction, thereby preparing a molding material. In the above-described process, as the addition type silicone rubber, was used silicon rubber, in which both Solution A and Solution B had a viscosity of 2,500 P, and a cured product thereof had a compression set of 6% at 150°C (by a measuring method in accordance with JIS K 6249) and tear strength of 30 kN/m at 23°C (by a measuring method in accordance with JIS K 6249).

Also, those (average coating amount: 2% by weight of the weight of core particles) obtained by using nickel particles as core particles and subjecting the core particles to electroless plating with gold were used as the conductive particles.

### [Production of anisotropically conductive sheet]

A one surface-side molding member and an other surface-side molding member each composed of a polyester resin sheet having a thickness of 0.1 mm were provided.

After a frame-like spacer having a rectangular opening of 150 mm x 150 mm and a thickness of 60 µm was then arranged on a molding surface of the other-side molding member, the molding material prepared was applied to within the opening of the spacer, and a reinforcing material formed of mesh was immersed in the molding material. Thereafter, the one surface-side molding member was arranged on this molding material in such a manner that its molding surface comes into contact with the molding material. Here, the mesh making up the reinforcing material are such that it is formed by polyallylate fiber having a fiber diameter of 23 µm and has dimensions of 150 mm x 150 nm x 42 µm, the number of openings is 130/cm, and the opening diameter is 54 µm.

Thereafter, a pressure roll device composed of a pressure roll and a supporting roll was used to pinch the molding material by the one surface-side molding member and other surface-side molding member, thereby forming a molding material layer having thickness of 60 µm between the one surface-side molding member and the other surface-side molding member.

Electromagnets were then arranged on respective back surfaces of the one surface-side molding member and the other surface-side molding member to subject the molding material layer to a curing treatment under conditions of 100°C for 1 hour while applying a parallel magnetic field of 1.5 T to the molding material layer in its thickness-wise direction, thereby producing a rectangular anisotropically conductive sheet having a thickness of 60 µm. This anisotropically conductive sheet is referred to as "anisotropically conductive sheet (a)".

In this anisotropically conductive sheet (a), a ratio of the thickness of the reinforcing material to the thickness of the anisotropically conductive sheet (a) is 0.7, and a ratio r/R of the number average particle diameter r of the conductive particles to the average opening diameter R of the mesh making up the reinforcing material is 0.28.

### [Production of inspection apparatus]

An inspection apparatus for circuit board, which is adapted to an inspection section of a rail-carried type automatic circuit board inspection machine "STARREC V5" (manufactured by NIDEC-READ CORPORATION), was produced under the following conditions in accordance with the construction shown in Fig. 9.

### [Inspection electrode plate device (25)]

Inspection electrode pins (26) are composed of brass subjected to a plating treatment with gold, and the overall length [length from a proximal surface of a body part (26A) to a tip surface of an electrode part (26B)] thereof is 5 mm. The specific dimensions of the respective parts are as follows. An outer diameter of the electrode part (26B) is 0.35 mm, a length of the electrode part (26B) is 0.1 mm, an outer diameter of the body part (26A) is 0.48 mm, a length of the body part (26A) is 4.9 mm, an outer diameter of a flange part (26C) is 0.55 mm, a thickness of the flange part (26C) is 0.1 mm, a length [length of a proximal portion in the body part (26A)] from a proximal end to a proximal-side end surface of the flange part (26C) in the body part (26A) is 3 mm, a length [length of a tip portion in the body part (26A)] from a tip end to a tip-side end surface of the flange part (26C) in the body part (26A) is 1.8 mm, and an arrangement pitch between the inspection electrode pins (26) is 0.75 mm.

An electrode pin-supporting member (27) is composed of a glass fiber-reinforced epoxy resin, a proximal-side supporting plate (28) has dimensions of 200 mm x 346 mm x 4.0 mm, and a tip-side supporting plate (29) has dimensions of 200 mm x 346 mm x 1.9 mm.

### [Upper-side adaptor (30)]

A circuit board (31) for connection has 5,844 rectangular connecting electrodes (32) and 5,844 circular terminal electrodes (33), a minimum connecting electrode (32) has dimensions of 60 µm x 150 µm, a minimum pitch between the connecting electrodes (32) is 200 µm, a diameter of the terminal electrodes (33) is 0.4 mm, and a pitch between the terminal electrodes (33) is 750 µm.

An anisotropically conductive sheet (10) is the anisotropically conductive sheet (a) described above.

### [Anisotropically conductive sheet (21)]

The anisotropically conductive sheet is a dispersion type anisotropically conductive sheet with nickel particles (average particle diameter: 35 µm) subjected to a plating treatment with gold contained in a proportion of 13% in terms of volume fraction in silicone rubber having a hardness of 30. The dimensions thereof are 100 mm x 110 mm x 0.25 mm.

### [Lower-side electrode plate device (45)]

Inspection electrode pins (46) are composed of brass subjected to a plating treatment with gold, and the overall length [length from a proximal surface of a body part (46A) to a tip surface of an electrode part (46B)] thereof is 5 mm. The specific dimensions of the respective parts are as follows. An outer diameter of the electrode part (46B) is 0.35 mm, a length of the electrode part (46B) is 0.1 mm, an outer diameter of the body part (46A) is 0.48 mm, a length of the body part (46A) is 4.9 mm, an outer diameter of a flange part (46C) is 0.55 mm, a thickness thereof is 0.55 mm, a length [length of a proximal portion in the body part (46A)] from a proximal end to a proximal-side end surface of the flange part (46C) in the body part (46A) is 3 mm, a length [length of a tip portion in the body part (46A)] from a tip end to a tip-side end surface of the flange part (46C) in the body part (46A) is 1.8 mm, and an arrangement pitch between the inspection electrode pins (46) is 0.75 mm.

An electrode pin-supporting member (47) is composed of a glass fiber-reinforced epoxy resin, a proximal-side supporting plate (48) has dimensions of 200 mm x 346 mm x 4.0 mm, a projected height of each projected part (48A) is 3.0 mm, and a tip-side supporting plate (49) has dimensions of 200 mm x 346 mm x 1.9 mm.

### [Lower-side adaptor (50)]

A circuit board (51) for connection has 4,362 rectangular connecting electrodes (52) and 4,362 circular terminal electrodes (53), a minimum connecting electrode (52) has dimensions of 60 µm x 150 µm, a minimum pitch between the connecting electrodes (52) is 200 µm, a diameter of the terminal electrodes (53) is 0.4 mm, and a pitch between the terminal electrodes (33) is 750 µm.

An anisotropically conductive sheet (10) is the anisotropically conductive sheet (a) described above.

### [Anisotropically conductive sheet (41)]

The anisotropically conductive sheet is a dispersion type anisotropically conductive sheet with nickel particles (average particle diameter: 35 µm) subjected to a plating treatment with gold contained in a proportion of 13% in terms of volume fraction in silicone rubber having a hardness of 30. The dimensions thereof are 100 mm x 110 mm x 0.25 mm.

### [Circuit board-holding mechanism 60]]

The circuit board-holding mechanism has an alignment movable plate having dimensions of 200 mm x 346 mm x 2.95 mm.

### [Upper-side jig-supporting mechanism (35)]

Supports (37) for upper-side jig is composed of brass, an outer diameter of a tip part thereof is 4 mm, and an overall length thereof is 67 mm. A center distance between adjoining supports (37) for upper-side jig is 32.25 mm in a lateral direction (a left and right direction in Fig. 9) and 24.75 mm in a vertical direction (a direction perpendicular to paper in Fig. 1).

### [Lower-side jig-supporting mechanism (55)]

Supports (57) for lower-side jig is composed of brass, an outer diameter of a tip part thereof is 4 mm, and an overall length thereof is 67 mm. A center distance between adjoining supports (57) for upper-side jig is 32.25 mm in a lateral direction (a left and right direction in Fig. 9) and 24.75 mm in a vertical direction (a direction perpendicular to paper in Fig. 1).

The positional relation between upper-side supporting points related to the supports (37) for upper-side jig and lower-side supporting points related to supports (57) for lower-side jig is as follows.

The positional relation is described with reference to Fig. 14. On the specific plane M1 of projection, one lower-side supporting point 57S is located at a central position of each of rectangular upper-side unit regions R1 partitioned by 4 adjoining upper-side supporting points 37S, and one upper-side supporting point 37S is located at a central position of each of rectangular lower-side unit regions R2 partitioned by 4 adjacent lower-side supporting points 57S.

A center distance a between 2 upper-side supporting points 37S located at apex positions diagonal with each other in the upper-side unit region R1 is 41 mm.

### [Evaluation of anisotropically conductive sheet]

With respect to the above-described inspection apparatus, a durability test on the anisotropically conductive sheets (a) in the upper-side adaptor and lower-side adaptor was conducted by means of a circuit board for evaluation of the following specification in accordance with the following method. The results are shown in Table 1.

### [Specification of circuit board for evaluation]

The overall dimensions of the circuit board for evaluation are 100 mm x 100 mm x 0.8 mm, the total number of upper-side electrodes to be inspected is 5,844, a diameter of a minimum upper-side electrode to be inspected is 0.1 mm, a minimum pitch thereof is 0.2 mm, the total number of lower-side electrodes to be inspected is 4,362, a diameter of a minimum lower-side electrode to be inspected is 0.1 mm, and a minimum pitch thereof is 0.2 mm.

### [Durability test]

The inspection apparatus was installed in an inspection section of a rail-carried type automatic circuit board inspection machine "STARREC V5" (manufactured by NIDEC-READ CORPORATION), and the circuit board for evaluation was set in the circuit board-holding mechanism of the inspection apparatus. After a pressurizing operation was then conducted prescribed times for the circuit board for evaluation under conditions of a press pressure of 180 kgf, an electric resistance value as to the circuit board for evaluation was measured 10 times under conditions of a press pressure of 180 kgf by applying a current of 1 mA between a connecting electrode of the circuit board for connection in the upper-side adaptor and a connecting electrode of the circuit board for connection in the lower-side adaptor. An inspection point (hereinafter referred to as "NG inspection point") at which the electric resistance value measured reached 100 Ω or higher was judged to be defective conduction to calculate out a proportion (hereinafter referred to as "proportion of NG inspection points") of the number of the NG inspection points to the total number of inspection points.

A proportion of NG inspection points was determined in the same manner as described above except that the anisotropically conductive sheets in the inspection apparatus were replaced by new ones, and the conditions of the press pressure in the pressurizing operation and electric resistance-measuring operation were changed to 200 kgf.

In an actual inspection of circuit boards, it is necessary that the proportion of NG inspection points is 0.01% or lower. If the proportion of NG inspection points exceeds 0.01%, there is a possibility that a non-defective circuit board to be inspected may be judged to be a defective, so that it is difficult to conduct the electrical inspection of circuit boards with high reliability.

### <Comparative Example 1>

An anisotropically conductive sheet was produced in the same manner as in Example 1 except that no reinforcing material was used. The anisotropically conductive sheet thus obtained is referred to as "anisotropically conductive sheet (b)". An inspection apparatus was produced in the same manner as in Example 1 except that the anisotropically conductive sheet (b) was used in place of the anisotropically conductive sheet (a) to conduct the durability test on the anisotropically conductive sheet. The results are shown in Table 1.

**Table 1**

| | | Proportion of NG Inspection Points (%) | | | | | | |
|---|---|---|---|---|---|---|---|---|
| Number of Pressurizing Operation (times) | | 1 | 3000 | 5000 | 10000 | 30000 | 50000 | 100000 |
| Example 1 | Press Pressure 180kgf | 0 | 0 | 0 | 0 | 0 | 0 | 0.08 |
| | Press Pressure 200kgf | 0 | 0 | 0 | 0 | 0 | 0.05 | 1.2 |
| Comparative Example 1 | Press Pressure 180kgf | 0 | 0 | 0 | 0 | 0.1 | 2.3 | Not Measured |
| | Press Pressure 200kgf | 0 | 0 | 0.03 | 1.4 | Not Measured | Not Measured | Not Measured |

| | | | | | | | | |
|---|---|---|---|---|---|---|---|---|
| As apparent from the results shown in Table 1, it was confirmed that the anisotropically conductive sheet according to the present invention permits stably retaining necessary conductivity over a long period of time even when it was used repeatedly over many times and thus has long service life. | | | | | | | | |

## Claims

1. An anisotropically conductive sheet comprising a base material composed of an insulating elastic polymeric substance and a great number of conductive particles exhibiting magnetism, which are contained in the base material in a state oriented in a thickness-wise direction of the sheet to form chains, wherein
an insulating reinforcing material formed of mesh is contained in the base material.

2. The anisotropically conductive sheet according to claim 1, wherein the mesh making up the reinforcing material is formed by organic fiber.

3. The anisotropically conductive sheet according to claim 1 or 2, wherein the chains by the conductive particles are formed in a state dispersed in a plane direction of the sheet.

4. The anisotropically conductive sheet according to any one of claims 1 to 3, which has a thickness of 20 to 500 µm.

5. The anisotropically conductive sheet according to any one of claims 1 to 4, wherein a ratio of the thickness of the reinforcing material to the thickness of the anisotropically conductive sheet is 0.1 to 1.

6. The anisotropically conductive sheet according to any one of claims 1 to 5, wherein an average opening diameter of the mesh making up the reinforcing material is 10 to 800 µm.

7. The anisotropically conductive sheet according to claim 6, wherein a ratio r/R of a number average particle diameter r of the conductive particles to the average opening diameter R of the mesh is 0.01 to 0.9.

8. A process for producing an anisotropically conductive sheet, which comprises the steps of:
preparing a flowable molding material comprising a polymeric substance-forming material, which will become an elastic polymeric substance by being cured, and conductive particles exhibiting magnetism contained in the polymeric substance-forming material,
forming a molding material layer containing a reinforcing material formed of mesh in a state immersed in the molding material, and
subjecting the molding material layer to a curing treatment while applying or after an application of a magnetic field to the molding material layer in a thickness-wise direction thereof.

9. An inspection apparatus for circuit boards, comprising the anisotropically conductive sheet according to any one of claims 1 to 7.
